# EUROPEAN PATENT APPLICATION

(11) **EP 4 672 321 A1**
(43) Date of publication of application: **31.12.2025**
(21) Application number: 25174355.5
(22) Date of filing: 06.05.2025
(51) Int. Cl.: H01L 23/15, H01L 23/498, H01L 23/00

(54) **HYBRID PANEL WITH A GLASS SUBSTRATE**

(30) Priority: 28.06.2024 US 202418758215
(71) Applicant: Intel Corporation, Santa Clara, CA 95054 (US)
(72) Inventor: Konchady, Manohar, Chandler, 85248 (US); Jimenez, Andrew, Mesa, 85210 (US); Nguyen, Son, Gilbert, 85296 (US); Tanaka, Hiroki, Gilbert, 85295 (US); Wang, Yekan, Chandler, 85286 (US); Pietambaram, Srinivas Venkata Ramanuja, Chandler, 85249 (US); May, Robert Alan, Chandler, 85249 (US); Vehonsky, Jacob, Chandler, 85224 (US); Bryks, Whitney, Tempe, 85284 (US); Shan, Bohan, Chandler, 85226 (US); Duan, Gang, Chandler, 85248 (US); Nie, Bai, Chandler, 85249 (US); Hu, Xiyu, Phoenix, 85044 (US); Duong, Benjamin, Phoenix, 85044 (US); Chen, Haobo, Chandler, 85249 (US); Marin, Brandon C., Gilbert, 85234 (US); Xie, Zhixin, Chandler, 85249 (US); Vickery, David, Gilbert, 85297 (US); Chakrapani, Nirupama, Chandler, 85249 (US); Seneviratne, Dilan, Phoenix, 85048 (US); Han, Jung Kyu, Chandler, 85248 (US); Heaton, Thomas, Gilbert, 85234 (US)
(74) Representative: Goddar, Heinz J.

(57) **Abstract**

Embodiments disclosed herein include an apparatus that includes a substrate that comprises a glass layer. In an embodiment, a frame is provided around the substrate, and a gap is provided between an edge of the substrate and an interior edge of the frame. In an embodiment, a fill layer is provided in the gap, and the fill layer comprises a dielectric material. In an embodiment, a ring is provided over the fill layer around a perimeter of the substrate. In an embodiment, the ring comprises a metallic material.

## Description

### BACKGROUND

Electronics packaging substrates often include a core. Existing core materials include organic dielectrics that may include fiber reinforcement materials. As devices continue to become more complex, better performing core materials are desired. A package core that includes a solid glass layer is one potential option. Glass cores enable stiffer substrates, flatter surfaces, and can improve electrical performance.

However, the fragile nature of glass makes full-size glass panel edges extremely vulnerable to damage due to frequent contact of the edges during handling and processing. Designated toolsets that can handle and process glass panels need to be specially designed, and they are not widely available in the industry. This leads to a high technology improvement cost in order to enable a switch from organic core processing to glass core processing in a high volume manufacturing (HVM) environment.

### BRIEF DESCRIPTION OF THE DRAWINGS

Figure 1 is a cross-sectional illustration of a hybrid panel with a glass substrate and an organic frame with a reinforcement ring across a gap between the glass substrate and the organic frame, in accordance with an embodiment.
Figures 2A - 2H are cross-sectional illustrations depicting a process for forming a hybrid panel with a glass substrate and an organic frame with a reinforcement ring across a gap between the glass substrate and the organic frame, in accordance with an embodiment.
Figure 2I is a flow diagram of a process for forming a hybrid panel with a reinforcement ring, in accordance with an embodiment.
Figure 3 is a cross-sectional illustration of a package substrate with a glass substrate that is embedded in a dielectric layer, in accordance with an embodiment.
Figures 4A - 4I are cross-sectional illustrations depicting a process for forming a package substrate with a glass substrate that is embedded in a dielectric layer using resin coated copper (RCC) layers, in accordance with an embodiment.
Figure 4J is a flow diagram of a process for forming a package substrate with a glass layer that is embedded in a dielectric layer using RCC layers, in accordance with an embodiment.
Figures 5A and 5B are cross-sectional illustrations of package substrates with a glass substrate embedded in a dielectric layer that includes metal frames above and/or below the glass substrate, in accordance with an embodiment.
Figures 6A - 6J are cross-sectional illustrations depicting a process for forming a package substrate with a glass substrate embedded in a dielectric layer with a metal frame over and/or under the glass substrate, in accordance with an embodiment.
Figure 6K is a flow diagram of a process for forming a package substrate with a glass substrate embedded in a dielectric layer with a metal frame over and/or under the glass substrate, in accordance with an embodiment.
Figures 7A - 7F are illustrations depicting a process for forming a hybrid panel with a frame formed around a glass substrate with an in-situ process, in accordance with an embodiment.
Figures 8A - 8E are illustrations depicting a process for forming a hybrid panel with a frame that includes dummy vias for improved mechanical coupling to a glass substrate, in accordance with an embodiment.
Figures 9A - 9C are illustrations depicting hybrid panels with frames that are formed with an in-situ process around a glass substrate, in accordance with an embodiment.
Figures 10A - 10G are cross-sectional illustrations depicting a process for forming a hybrid panel with a frame formed with an in-situ process around a glass substrate and a dielectric layer, in accordance with an embodiment.
Figures 11A and 11B are cross-sectional illustrations of hybrid panels with a frame formed with an in-situ process around a glass substrate, in accordance with an embodiment.
Figure 12 is a flow diagram of a process for forming a hybrid frame with an in-situ frame formation around a glass substrate, in accordance with an embodiment.
Figure 13 is a schematic of a computing device built in accordance with an embodiment.

### EMBODIMENTS OF THE PRESENT DISCLOSURE

Described herein are hybrid panels with a glass substrate, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, package substrates that include glass cores have the potential to improve some manufacturing processes and enable higher performing devices compared to existing organic core solutions. However, glass substrates are fragile. For example, contact to the edge of the glass substrate can lead to chipping, cracking, and/or the like. The development of new processing tools is one option for handling glass core substrates, but such an approach would be expensive.

Frames have been used in order to protect the glass substrates. In such solutions, the glass substrate is placed within the frame. An encapsulation layer bonds the frame to the glass substrate. However, the bond between the frame and the glass substrate is a potential point of weakness in the assembly. For example, high stress around the gap between the frame and the glass substrate can lead to delamination and/or other defects. Accordingly, existing frame solutions are not suitable for high yielding high volume manufacturing (HVM) solutions. Accordingly, embodiments disclosed herein include several different solutions for providing improved hybrid panel solutions.

In a first embodiment, the joint between the frame and the glass substrate is reinforced with a metallic reinforcement ring that is provided over the frame and the glass substrate. The metallic reinforcement ring may be formed with a deposition and lithographic patterning process in order to provide precise placement of the reinforcement ring across the gap between the frame and the glass substrate.

A second embodiment includes the formation of glass core package substrates through the use of a hybrid panel solution that uses resin coated copper (RCC) layers (or any other resin coated metal layer) that are applied across the glass substrate and the surrounding frame. The resin of the RCC can flow into the gap between the edge of the glass substrate and the frame. Since the resin fills the gap, the edge of the glass substrate is protected in subsequent processing operations after singulation from the hybrid panel. For example, the resulting package substrate may include a glass core with a sidewall that is coated by the resin of the RCC. In an embodiment, the copper layer of the RCC can also be used as a layer within the package substrate (e.g., for routing or the like).

A third embodiment includes the formation of reconstituted panel that is used to form glass core package substrates. The reconstituted panel allows for a plurality of glass substrate units to be embedded between a pair of RCC films. The resin from the RCC films will fill the gap between the glass substrate units in order to fully embed the glass substrate units. A metallic frame may also be provided over and/or under the glass substrate units. The metallic frame may be patterned from the copper layer of the RCC film. In some embodiments, the reconstituted panel solution allows for simple singulation, since the cut line will not need to pass through glass. Additionally, the singulated glass substrate unit will have sidewalls that are protected by the resin in order to provide improved protection to the glass substrate unit.

A fourth embodiment includes the formation of a hybrid panel that includes a metallic frame that is plated over the glass substrate with an in-situ process. The plated metallic frame results in there being no misalignment between the glass substrate and the frame. Further, there is no need for an overmolding material that mechanically couples the glass substrate to the frame. As such, thickness uniformity of the hybrid panel remains excellent. Since the frame is plated with the in-situ process, there is also no need for the separate manufacture of frame components. The frame may also comprise dummy vias between a top portion of the frame and a bottom portion of the frame in order to improve mechanical coupling with the glass substrate. In an embodiment, the adhesion of the frame to the glass substrate may be improved by roughening a surface of the glass substrate. A copper foil (or other metallic foil) is applied to the roughened surface in order to provide a conductive layer from which the frame can be plated. The copper foil may conform to the roughened surface in order to provide the desired adhesion strength.

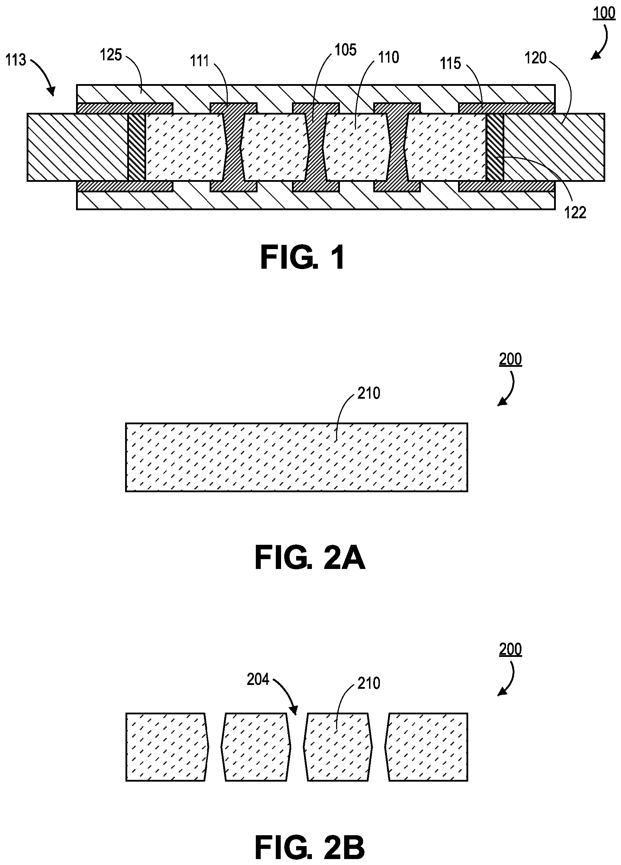

Referring now to Figure 1, a cross-sectional illustration of a hybrid panel 100 is shown, in accordance with an embodiment. In an embodiment, the hybrid panel 100 comprises a glass substrate 110. The glass substrate 110 may have any suitable form factor. In a particular embodiment, the glass substrate 110 comprises a panel form factor or a quarter panel form factor. In an embodiment, the glass substrate 110 comprises a glass material that is suitable for forming the core of a package substrate.

In an embodiment, the glass substrate 110 may be substantially all glass. The glass substrate 110 may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, glass substrate 110 may be distinguished from, for example, the "prepreg" or "FR4" core of a Printed Circuit Board (PCB) substrate which typically comprises glass fibers embedded in a resinous organic material, such as an epoxy.

The glass substrate 110 may have any suitable dimensions. In a particular embodiment, the glass substrate 110 may have a thickness that is approximately 50µm or greater. For example, the thickness of the glass substrate 110 may be between approximately 50µm and approximately 1.4mm. Though, smaller or larger thicknesses may also be used. Individual units (after singulation) from the glass substrate 110 may have edge dimensions (e.g., length, width, etc.) that are approximately 10mm or greater. For example, edge dimensions may be between approximately 10mm to approximately 250mm. Though, larger or smaller edge dimensions may also be used. More generally, the area dimensions of the individual units in the glass substrate 110 (from an overhead plan view) may be between approximately 10mm x 10mm and approximately 250mm x 250mm. In an embodiment, the glass substrate 110 may have a first side that is perpendicular or orthogonal to a second side. In a more general embodiment, the glass substrate 110 may comprise a rectangular prism volume with sections (e.g., vias) removed and filled with other materials (e.g., metal, etc.).

The glass substrate 110 may comprise a single monolithic layer of glass. In other embodiments, the glass substrate 110 may comprise two or more discrete layers of glass that are stacked over each other. The discrete layers of glass may be provided in direct contact with each other, or the discrete layers of glass may be mechanically coupled to each other by an adhesive or the like. The discrete layers of glass in the glass substrate 110 may each have a thickness less than approximately 50µm. For example, discrete layers of glass in the glass substrate 110 may have thicknesses between approximately 25µm and approximately 50µm. Though, discrete layers of glass may have larger or smaller thicknesses in some embodiments. As used herein, "approximately" may refer to a range of values within ten percent of the stated value. For example approximately 50µm may refer to a range between 45µm and 55µm.

The glass substrate 110 may be any suitable glass formulation that has the necessary mechanical robustness and compatibility with semiconductor packaging manufacturing and assembly processes. For example, the glass substrate 110 may comprise aluminosilicate glass, borosilicate glass, alumino-borosilicate glass, silica, fused silica, or the like. In some embodiments, the glass substrate 110 may include one or more additives, such as, but not limited to, Al₂O₃, B₂O₃, MgO, CaO, SrO, BaO, SnO₂, Na₂O, K₂O, SrO, P₂O₃, ZrO₂, Li₂O, Ti, or Zn. More generally, the glass substrate 110 may comprise silicon and oxygen, as well as any one or more of aluminum, boron, magnesium, calcium, barium, tin, sodium, potassium, strontium, phosphorus, zirconium, lithium, titanium, or zinc. In an embodiment, the glass substrate 110 may comprise at least 23 percent silicon (by weight) and at least 26 percent oxygen (by weight). In some embodiments, the glass substrate 110 may further comprise at least 5 percent aluminum (by weight).

In an embodiment, the glass substrate 110 may be surrounded by a frame 120. The frame 120 may comprise an organic dielectric material. The use of an organic dielectric material based frame 120 is useful since existing panel level processing equipment may already be set up for handling such materials. As such, new HVM equipment may not be necessary to form and process the hybrid panel 100. In the illustrated embodiment, the frame 120 is a monolithic structure. Though, other embodiments may include a frame that comprise metal layers (e.g., copper) over a top and/or bottom surface of the frame 120.

In an embodiment, a gap may be provided between an interior surface of the frame 120 and an outer edge of the glass substrate 110. The gap may be filled with a fill layer 122 that is a dielectric material, such as an organic dielectric material. For example, the fill layer 122 may comprise a buildup film material typical of electronics packaging manufacturing. In order to reinforce the strength of the joint between the frame 120 and the glass substrate 110, a reinforcement ring 115 may be provided over and/or under the glass substrate 110 and the frame 120. The reinforcement ring 115 may be a metallic material, such as copper. The reinforcement ring 115 may extend across the fill layer 122 and be within a footprint of both the glass substrate 110 and the frame 120. In an embodiment, an outer region 113 of the frame 120 remains exposed (i.e., the outer region 113 is not covered by the reinforcement ring 115) to allow for clamping and/or handling the hybrid panel 100 with existing tool sets.

As will be described in greater detail below, the reinforcement ring 115 may be formed in parallel with the formation of vias 105 through the glass substrate 110 and pads 111 over and/or under the vias 105. Accordingly, a thickness of the reinforcement ring 115 may be substantially equal to a thickness of the pads 111 since they are patterned from the same layer. In an embodiment, the vias 105 may have any suitable cross-sectional profile. For example, an hourglass shaped profile is shown in Figure 1. Though, vias 105 with vertical sidewalls or vias 105 with a single taper may also be included in some embodiments.

In an embodiment, the reinforcement ring 115 is a continuous ring that surrounds (and partially overlaps) a perimeter of the glass substrate 110. Though, in other embodiments, the reinforcement ring 115 may comprise a plurality of segments around the perimeter of the glass substrate 110. The particular design of the reinforcement ring 115 is flexible since the reinforcement ring 115 may be patterned with a lithographic process. Additionally, the use of a lithographic process allows for higher alignment precision compared to manual placement.

In an embodiment, buildup layers 125 may also be provided over and/or under the hybrid panel 100. The buildup layers 125 may comprise electrically conductive routing (e.g., pads, traces, etc.) that provide electrical coupling through a thickness of the hybrid panel 100. In an embodiment, the buildup layers 125 are shown with a different shading than the fill layer 122. Though, in some embodiments, the buildup layers 125 may comprise the same or similar material as the fill layer 122.

Referring now to Figures 2A - 2H, a series of cross-sectional illustrations depicting a process for forming a hybrid panel 200 is shown, in accordance with an embodiment. In an embodiment, the hybrid panel 200 fabricated in Figures 2A - 2H may be similar to the hybrid panel 100 described in greater detail herein.

Referring now to Figure 2A, a cross-sectional illustration of a hybrid panel 200 at a stage of manufacture is shown, in accordance with an embodiment. As shown, the hybrid panel comprises a glass substrate 210. In an embodiment, the glass substrate 210 may be similar to any of the glass substrates described in greater detail herein. The glass substrate 210 may have a panel form factor or a quarter panel form factor in some embodiments.

Referring now to Figure 2B, a cross-sectional illustration of the hybrid panel 200 after via openings 204 are formed through a thickness of the substrate 210 is shown, in accordance with an embodiment. In an embodiment, the via openings 204 may be formed with any suitable subtractive process. For example, a laser assisted etching process may be used to form the via openings 204. In such an embodiment, a laser exposure of the glass substrate 210 locally modifies a structure of the glass substrate 210 in order to render the exposed areas more reactive to an etching chemistry. In such an embodiment, the via openings 204 may have an hourglass shaped profile or a profile with a single taper. Though, other processes (e.g., etching, ablation, etc.) may be used to form the via openings 204. The via openings 204 may also have substantially vertical sidewalls in some embodiments.

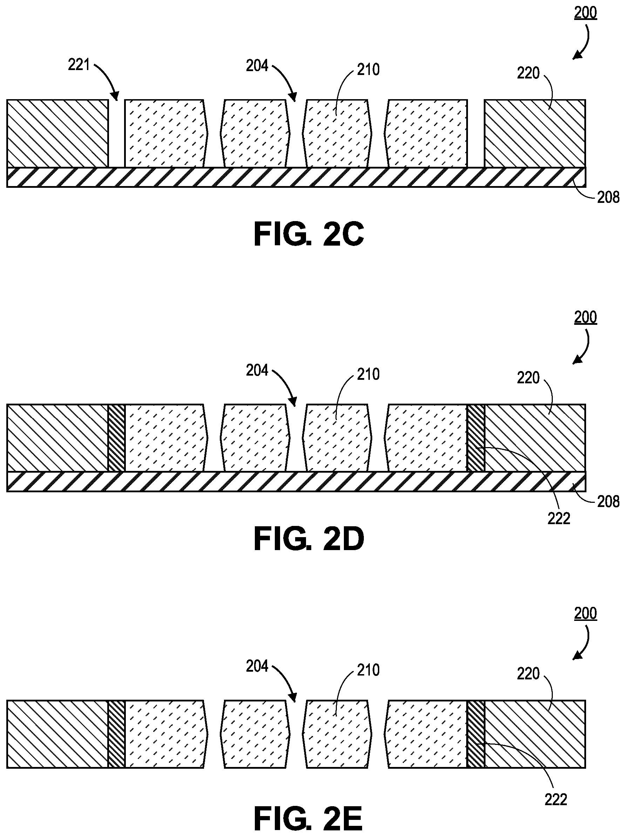

Referring now to Figure 2C, a cross-sectional illustration of the hybrid panel 200 after the glass substrate 210 is placed on a carrier 208 within an opening of a frame 220 is shown, in accordance with an embodiment. In an embodiment, the carrier 208 may be any suitable rigid material (e.g., glass, silicon, etc.). In some embodiments, a release layer (not shown) may also be provided over the carrier 208. The frame 220 may also be placed on the carrier 208. In an embodiment, a gap 221 may be provided between an inner edge of the frame 220 and an edge of the glass substrate 210.

Referring now to Figure 2D, a cross-sectional illustration of the hybrid panel 200 after a fill layer 222 is deposited into the gap 221 is shown, in accordance with an embodiment. In an embodiment, the fill layer 222 may be deposited into the gap 221 with a liquid dispensing process. The liquid may be cured (e.g., with heat, ultraviolet (UV) exposure, etc.) in order to form the solidified fill layer 222.

Referring now to Figure 2E, a cross-sectional illustration of the hybrid panel 200 after the carrier 208 is removed is shown, in accordance with an embodiment. The carrier 208 may be removed by deactivating a release layer with a suitable stimulus. In an embodiment, the resulting hybrid panel 200 includes a top surface and a bottom surface that is fully exposed.

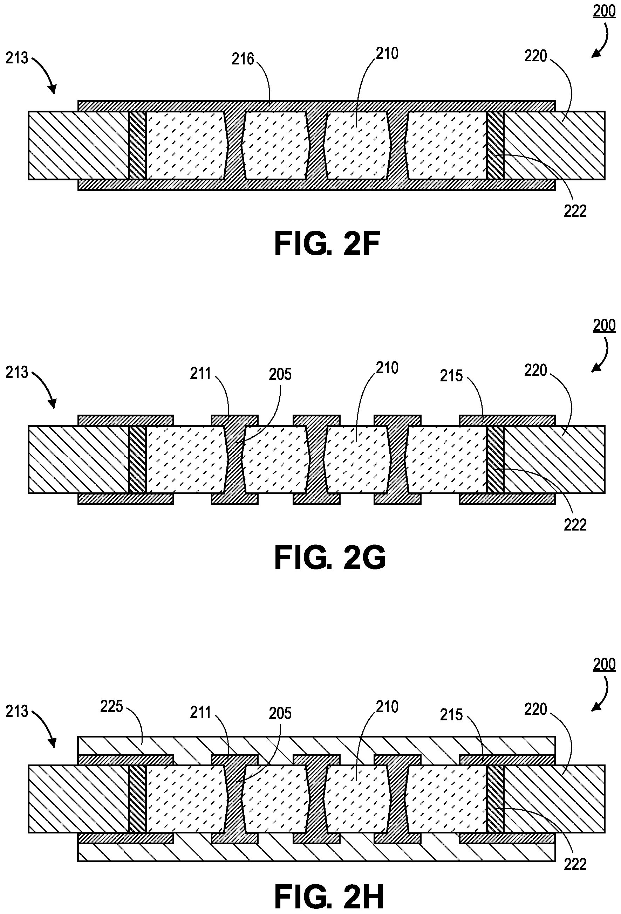

Referring now to Figure 2F, a cross-sectional illustration of the hybrid panel 200 after a metal layer 216 is deposited over the hybrid panel 200 is shown, in accordance with an embodiment. In an embodiment, the metal layer 216 may be formed with a plating process, such as an electroplating process. In such an embodiment, a seed layer (not shown) may be provided over the surfaces of the glass substrate 210 (including the via openings 204), over the fill layer 222, and over at least a portion of the frame 220 (if there is no metal layer over the top and bottom of the frame 220). In an embodiment, an outer region 213 of the frame 220 is protected from the plating process (e.g., with a resist or the like) in order to preserve an exposed portion of the frame 220 at the outer region 213.

Referring now to Figure 2G, a cross-sectional illustration of the hybrid panel 200 after a patterning process is used to define metal features within the hybrid panel 200 is shown, in accordance with an embodiment. In an embodiment, the metal layer 216 may have a resist provided over the regions that are to remain on the hybrid panel 200. An etching process may then be used to define the metal features, such as vias 205, pads 211 over the vias 205, and a reinforcement ring 215.

In Figures 2E and 2F, a plating process followed by an etching process is shown. Though, it is to be appreciated that the metal features may be defined with any suitable process. For example, a patterned resist may be provided over the seed layer, and the plating may plate up the metal features only in the desired locations. The resist layer can be removed, and the seed layer below the resist layer can be removed to electrically isolate the metal features.

The reinforcement ring 215 may extend across the fill layer 222 and be within a footprint of both the glass substrate 210 and the frame 220. In an embodiment, the outer region 213 of the frame remains exposed (i.e., the outer region 213 is not covered by the reinforcement ring 215) to allow for clamping and/or handling the hybrid panel 200 with existing tool sets.

Since the reinforcement ring 215 is formed in parallel with the pads 211, a thickness of the reinforcement ring 215 may be substantially equal to a thickness of the pads 211. In an embodiment, the reinforcement ring 215 is a continuous ring that surrounds (and partially overlaps) a perimeter of the glass substrate 210. Though, in other embodiments, the reinforcement ring 215 may comprise a plurality of segments around the perimeter of the glass substrate 210. The particular design of the reinforcement ring 215 is flexible since the reinforcement ring 215 is patterned with a lithographic process. Additionally, the use of a lithographic process allows for higher alignment precision in order to provide the necessary reinforcement strength to the hybrid panel 200.

Referring now to Figure 2H, a cross-sectional illustration of the hybrid panel 200 after buildup layers 225 are applied over and/or under the hybrid panel 200 is shown, in accordance with an embodiment. The buildup layers 225 may comprise a buildup film or the like. The buildup layers 225 may be applied with a lamination process. Electrically conductive features (e.g., pads, traces, vias, etc.) (not shown in Figure 2H) may also be integrated into the buildup layers 225 using standard electronics packaging manufacturing processes. After the desired number of buildup layers 225 are formed, the hybrid panel 200 may be singulated into individual devices (e.g., package substrates) that comprise glass cores (which are part of the original glass substrate 210).

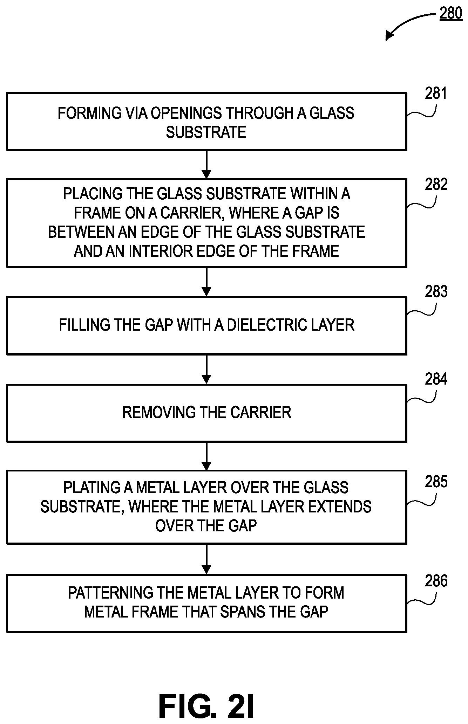

Referring now to Figure 2I, a flow diagram of a process 280 for forming a hybrid panel is shown, in accordance with an embodiment. In an embodiment, the process 280 may be used to form a hybrid panel that is similar to the hybrid panel 200 described in greater detail herein. In an embodiment, the process 280 may begin with operation 281, which comprises forming via openings through a glass substrate. In an embodiment, the glass substrate may be similar to any of the glass substrates described in greater detail herein. The via openings may be formed with any suitable process, such as a laser assisted etching process.

In an embodiment, the process 280 may continue with operation 282, which comprises placing the glass substrate within a frame on a carrier. In an embodiment, a gap is provided between an edge of the glass substrate and an interior edge of the frame. The carrier may have a release layer in some embodiments.

In an embodiment, the process 280 may continue with operation 283, which comprises filling the gap with a dielectric layer. In an embodiment, the dielectric layer may be applied with a liquid dispensing process, and the liquid may be cured. In an embodiment, the process 280 may continue with operation 284, which comprises removing the carrier.

In an embodiment, the process 280 may continue with operation 285, which comprises plating a metal layer over the glass substrate. In an embodiment, the metal layer extends over the gap. In an embodiment, the process 280 may continue with operation 286, which comprises patterning the metal layer to form a metal frame that spans the gap.

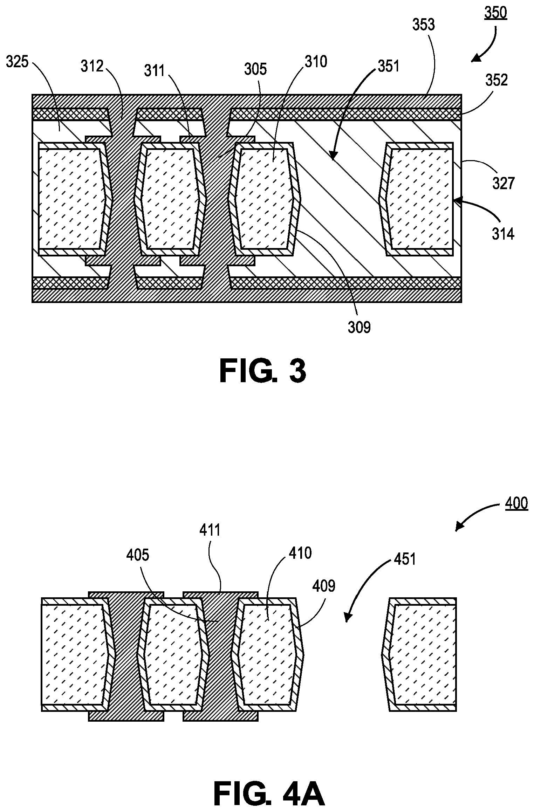

Referring now to Figure 3, a cross-sectional illustration of a portion of a package substrate 350 that is fabricated from a hybrid panel is shown, in accordance with an embodiment. In an embodiment, the package substrate 350 may comprise a glass substrate 310 (which may sometimes be referred to as a glass core). In an embodiment, the glass substrate 310 may be similar to any of the glass substrates described in greater detail herein. In an embodiment the glass substrate 310 may comprise one or more vias 305 that pass through a thickness of the glass substrate 310. The vias 305 may have hourglass shaped cross-sections, tapered cross-sections, rectangular cross-sections, or the like. In an embodiment, pads 311 may be provided over and/or under the vias 305. In some embodiments, the glass substrate 310 may also comprise a hole 351 through a thickness of the glass substrate 310. The hole 351 may be used for housing one or more components (not shown). Components may include passive components (e.g., resistors, capacitors, inductors, or the like). In the illustrated embodiment, the hole 351 is filled with the dielectric layer 325 that surrounds the glass substrate 310. In an embodiment, surfaces of the glass substrate 310 may comprise a seed layer 309. The seed layer 309 may comprise copper, titanium, platinum, and/or the like.

In an embodiment, the dielectric layer 325 may be provided over a top surface of the glass substrate 310, a bottom surface of the glass substrate 310, and one or more sidewalls of the glass substrate 310. For example, a sidewall portion 327 of the dielectric layer 325 may be provided along one or more of the sidewall surfaces 314 of the glass substrate 310. The presence of the sidewall portion 327 may be the result of a singulation process where the cut line passes between a frame (not shown) and an edge of the glass substrate 310 (as will be described in greater detail herein).

In an embodiment, the dielectric layer 325 may be a resin component of one or more RCC films (or other metal-resin films). As shown, a first RCC film is provided over the glass substrate 310 and a second RCC film is provided under the glass substrate 310. Each RCC film may comprise a metal layer 352. The metal layer 352 may extend across an entire width of the package substrate 350 in some embodiments. Though, the metal layer 352 may be patterned in order to form electrically isolated features in other embodiments. In an embodiment, a plated metal layer 353 may also be provided over (or under) the metal layer 352 of the RCC film. In some embodiments, the plated metal layer 353 and the metal layer 352 of the RCC film are different metals. Though, even when the metal layer 352 of the RCC film and the plated metal layer 353 comprise the same metal, a seam may be visible under some analytical techniques. Accordingly, the presence of a stacked metal structure (e.g., the metal layer 352 of the RCC film and the plated metal layer 353) may be an indication that a hybrid panel process was used to fabricate the package substrate 350. Further, in some embodiments, the presence of a sagging metal layer 352 and plated metal layer 353 (i.e., a non-planar metal layer 352 or plated metal layer 353) may be provided over the hole 351 as a result of the assembly process (as will be described in greater detail below). Such a sagging layer (or layers) may be another indication that a process similar to the one described herein was used to fabricate the package substrate 350.

In an embodiment, the package substrate may also comprise a via 312 that passes from the plated metal layer 353 to a pad 311. The via 312 may pass through the underlying metal layer 352 of the RCC film. Accordingly, a tapered seam may be provided through the metal layer 352, even though both the via 312 and the metal layer 352 comprise metal. The via 312 may be plated with the same process used to plate the plated metal layer 353. As such, the via 312 and the plated metal layer 353 may have a seamless interface, and the via 312 and the plated metal layer 353 may comprise the same material.

Referring now to Figures 4A - 4I, a series of cross-sectional illustrations depicting a process for forming a package substrate 450 with a hybrid panel process is shown, in accordance with an embodiment.

Referring now to Figure 4A, a cross-sectional illustration of a portion of a hybrid panel 400 at a stage of manufacture is shown, in accordance with an embodiment. As shown, the hybrid panel 400 may comprise a glass substrate 410. The glass substrate 410 may be similar to any of the glass substrates described in greater detail herein. In an embodiment, vias 405 may be formed through a thickness of the glass substrate 410. The vias 405 may be formed with any suitable process (e.g., laser assisted etching followed by a plating process up from a seed layer 409). Pads 411 may be provided over and/or under the vias 405. In an embodiment, a hole 451 may also be provided through a thickness of the glass substrate 410. The hole 451 may be formed with the patterning process used to form the openings for the vias 405. However, during the plating to form the vias 405, the hole 451 may be blocked (e.g., with a resist or the like).

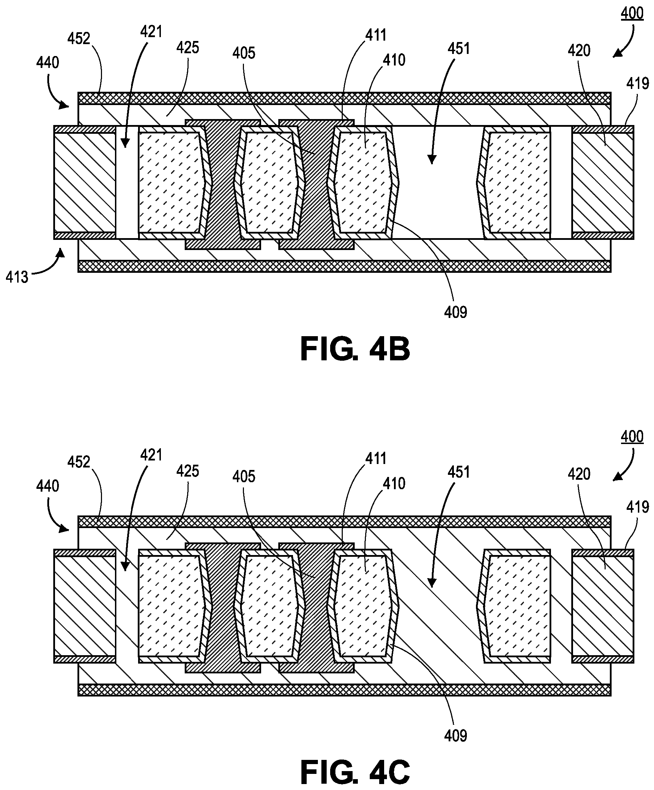

Referring now to Figure 4B, a cross-sectional illustration of the hybrid panel 400 after the glass substrate 410 is set into a frame 420 and RCC films 440 are applied over and/or under the hybrid panel 400 is shown, in accordance with an embodiment. In an embodiment, the frame 420 may comprise an organic dielectric material. A metallic layer 419 may be provided over and/or under the frame 420 in some embodiments. As such, the frame 420 allows for subsequent handling and processing with existing HVM panel processing tool sets. In an embodiment, a gap 421 may be provided between an edge of the glass substrate 410 and an interior edge of the frame 420.

In an embodiment, RCC films 440 may be applied over the top surface and the bottom surface of the hybrid panel 400. While referred to as an RCC film 440, it is to be appreciated that any resin coated metal film may be used. The RCC films 440 are laminated over the hybrid panel 400 so that the dielectric layer 425 (e.g., a resin) is facing the glass substrate 410, and the metal layer 452 is separated from the glass substrate 410 by the dielectric layer 425. The use of a laminated RCC film 440 provides several benefits. One benefit is that the metal layer 452 provides enhanced strength to the hybrid panel 400. Particularly, the joint over the gap 421 is a weak point where delamination may occur. The metal layer 452 overlying the gap 421 reinforces this weak point in order to improve the mechanical reliability of the hybrid panel 400. Additionally, a single lamination step is used to apply the RCC film 440 as opposed to the need to add a plurality of reinforcement strips across the gap 421. Lamination tools are well developed and readily available, whereas strip application would require a manual process.

In an embodiment, the RCC film 440 also spans across the hole 451. While shown as perfectly flat across the hole 451, it is to be appreciated that the RCC film 440 may sag into the hole 451 to some extent. Accordingly, in a resulting package substrate, the presence of a sagging metal layer 452 (i.e., a non-planar metal layer 452) over the hole 451 may be an indication that a process similar to the one described herein was used to fabricate the package substrate.

In an embodiment, an outer region 413 of the frame 420 remains exposed (i.e., the outer region 413 is not covered by the RCC film 440) to allow for clamping and/or handling the hybrid panel 400 with existing tool sets. Since a lamination process is used for the application of the RCC film 440, there is no need for additional patterning or etching in order to maintain the exposed outer region 413 of the frame 420.

Referring now to Figure 4C, a cross-sectional illustration of the hybrid panel 400 after the dielectric layer 425 fills the gap 421 and the hole 451 is shown, in accordance with an embodiment. In an embodiment, the dielectric layer 425 may fill the gap 421 and the hole 451 by pressing the RCC film 440 down against the glass substrate 410 and the frame 420.

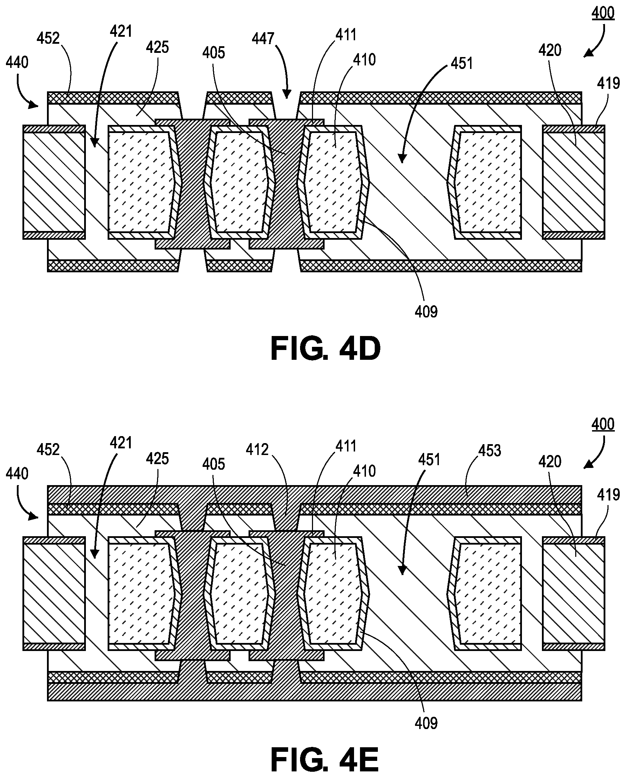

Referring now to Figure 4D, a cross-sectional illustration of the hybrid panel 400 after via openings 447 are formed through the metal layer 452 and a portion of the dielectric layer 425 is shown, in accordance with an embodiment. In an embodiment, the via openings 447 may be formed with a laser ablation process or any other suitable patterning process. The via openings 447 are positioned so that they expose portions of the pads 411.

Referring now to Figure 4E, a cross-sectional illustration of the hybrid panel 400 after a plated metal layer 453 is formed over the metal layer 452 of the RCC film 440 is shown, in accordance with an embodiment. In an embodiment, the metal layer 453 may be formed with an electroplating process or the like. The plating process may also result in the formation of the vias 412 that couple the plated metal layer 453 to the pads 411.

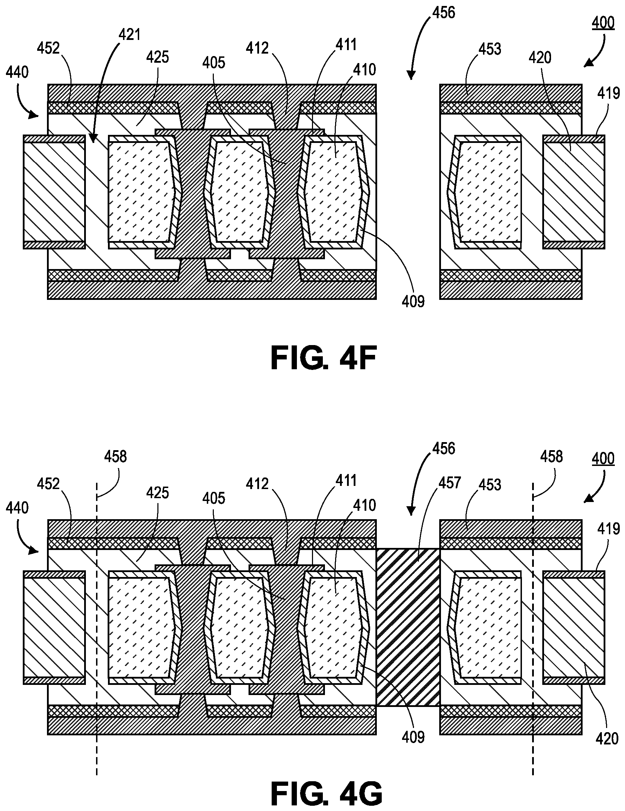

Referring now to Figure 4F, a cross-sectional illustration of the hybrid panel 400 after a hole 456 is formed through the dielectric layer 452 is shown, in accordance with an embodiment. The hole 456 may be located within the hole 451 that was previously formed through the glass substrate 410. The hole 456 may be formed with a drilling process, an ablation process, an etching process, or the like.

Referring now to Figure 4G, a cross-sectional illustration of the hybrid panel 400 after a component 457 is placed within the hole 456 is shown, in accordance with an embodiment. In an embodiment, the component 457 may be a passive device. The component 457 may be a discrete device that is placed into the hole 456. In other embodiments, the component 457 may be an integrated device. For example, the component 457 may comprise a coaxial magnetic composite core inductor or the like.

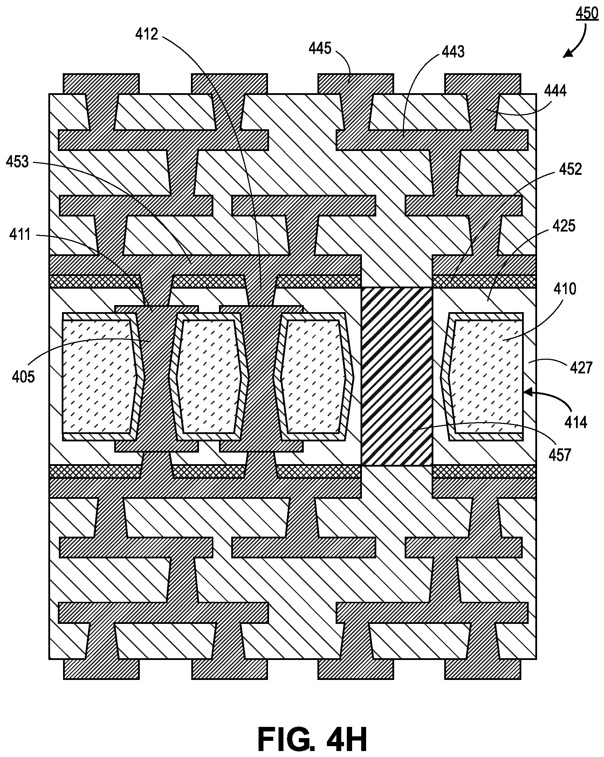

Referring now to Figure 4H, a cross-sectional illustration of a package substrate 450 that is singulated from the hybrid panel 400 is shown, in accordance with an embodiment. In an embodiment, the package substrate 450 may comprise the addition of one or more buildup layers 425 over the metal layers 453. The buildup layers 425 may also comprise electrical routing (e.g., vias 444, traces 443, pads 445, etc.) that is coupled to the vias 405.

After the additional buildup layers 425 are formed, the hybrid panel 400 may be singulated. For example, the hybrid panel 400 may be singulated along cut lines 458 (shown in Figure 4G). As shown, sidewall portions 427 of the buildup layer 425 may remain along one or more sidewall surfaces 414 of the glass substrate 410. Accordingly, the glass substrate 410 remains protected, even after the frame 420 is removed.

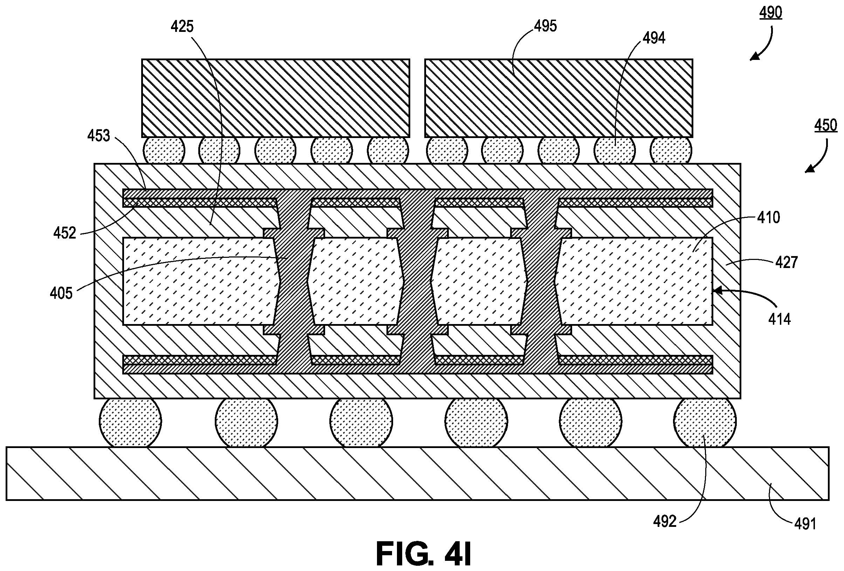

Referring now to Figure 4I, a cross-sectional illustration of an electronic system 490 is shown, in accordance with an embodiment. The electronic system 490 may comprise a board 491, such as a printed circuit board (PCB), a motherboard, or the like. In an embodiment, a package substrate 450 may be coupled to the board 491 by interconnects 492. The interconnects 492 may comprise any suitable second level interconnect (SLI) architecture, such as solder bumps, sockets, pins, or the like.

In an embodiment, the package substrate 450 may be similar to the package substrate 450 formed with a hybrid panel using a process similar to the one described above with respect to Figures 4A - 4J. For example, a glass substrate 410 (i.e., a glass core) may have vias 405 that are coupled to a metal layer 453. The metal layer 453 may be provided over a metal layer 452 of an RCC film. Additionally, sidewall portions 427 of the buildup layer 425 may cover sidewall surfaces 414 of the glass substrate 410.

In an embodiment, one or more dies 495 may be coupled to the package substrate 450 by interconnects 494. The interconnects 494 may include any suitable first level interconnect (FLI) architecture, such as solder, copper bumps, hybrid bonding interfaces, or the like. The dies 495 may comprise one or more types of dies, such as a processor (e.g., a central processing unit (CPU), a graphics processing unit (GPU), etc.), a communications die, a memory die, and/or the like.

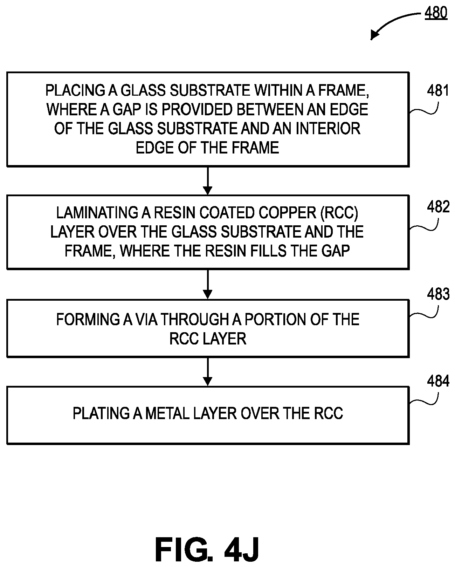

Referring now to Figure 4J, a flow diagram of a process 480 for forming a hybrid panel is shown, in accordance with an embodiment. In an embodiment, the hybrid panel formed with process 480 may be similar to the hybrid panel 400 described in greater detail herein. In an embodiment, the process 480 may begin with operation 481, which comprises placing a glass substrate within a frame. In an embodiment, a gap is provided between an edge of the glass substrate and an interior edge of the frame.

In an embodiment, the process 480 may continue with operation 482, which comprises laminating an RCC layer over the glass substrate and the frame. In an embodiment, the resin of the RCC at least partially fills the gap. The RCC layer may also include any type of resin coated metal layer. In an embodiment, the process 480 may continue with operation 483, which comprises forming a via through a portion of the RCC layer. In an embodiment, the process 480 may continue with operation 484, which comprises plating a metal layer over the RCC layer. While described as separate operations, it is to be appreciated that the via and the plated metal layer over the RCC layer may be formed with a single plating process.

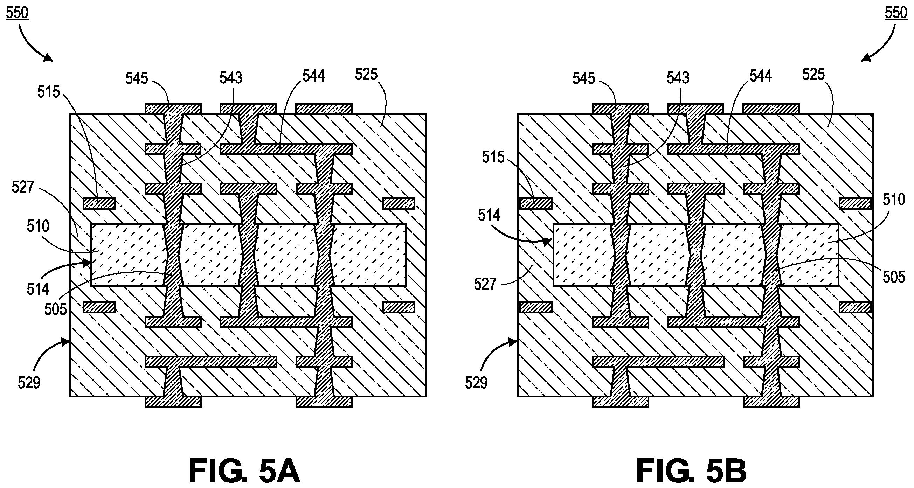

Referring now to Figures 5A and 5B, a pair of cross-sectional illustrations depicting package substrates 550 that are formed with a reconstituted panel process is shown, in accordance with an embodiment.

Referring now to Figure 5A, a cross-sectional illustration of the package substrate 550 is shown, in accordance with an embodiment. In an embodiment, the package substrate 550 comprises a glass substrate 510 (i.e., a glass core). In an embodiment, the glass substrate 510 may be similar to any of the glass substrates described in greater detail herein. In an embodiment, the glass substrate 510 may comprise one or more vias 505 that pass through a thickness of the glass substrate 510. The vias 505 in Figure 5A include hourglass shaped cross-sectional shapes. Though, vias 505 may have any suitable cross-sectional shape, such as having a single taper, substantially vertical sidewalls, or the like.

In an embodiment, a dielectric layer 525 is provided around the glass substrate 510. For example, the glass substrate 510 may be entirely embedded within the dielectric layer 525. That is, the dielectric layer 525 may be provided over a top surface of the glass substrate 510, a bottom surface of the glass substrate 510, and sidewalls surfaces 514 of the glass substrate 510. For example, sidewall portions 527 of the dielectric layer 525 may line the sidewall surfaces 514 of the glass substrate 510.

In an embodiment, a frame 515 may be provided around a perimeter of the glass substrate 510. More particularly, the frame 515 may be above and/or below the glass substrate 510, and the sidewalls surfaces 514 of the glass substrate 510 may be within a footprint of the frame 515. In an embodiment, the outer edge of the frame 515 may be set back from an edge 529 of the dielectric layer 525. Additionally, a portion of the dielectric layer 525 may be provided between the frame 515 and the glass substrate 510. In an embodiment, the frame 515 is a metallic material, such as copper. In an embodiment, the frame 515 is a continuous ring that covers an entire perimeter of the glass substrate 510. In other embodiments, the frame 515 may include a plurality of sections that are positioned around a perimeter of the glass substrate 510.

In an embodiment, electrical routing (e.g., pads 545, traces 544, vias 543, etc.) may be provided within the dielectric layer 525. In one embodiment, vias 543 may land directly on the vias 505 of the glass substrate 510. Though, in other embodiments, a pad (not shown) may be provided between the via 543 and the via 505 of the glass substrate 510. As shown, the frame 515 may be at a height within the dielectric layer 525 that is between the layer of pads 545 closest to the glass substrate 510 and the glass substrate 510. That is, the frame 515 and the via 543 that contacts the via 505 may overlap in the thickness direction of the package substrate 550.

Referring now to Figure 5B, a cross-sectional illustration of a package substrate 550 is shown, in accordance with an additional embodiment. The package substrate 550 in Figure 5B may be similar to the package substrate 550 in Figure 5A, with the exception of the placement of the frame 515. Instead of the frame 515 overlapping the sidewall surface 514 of the glass substrate 510, the interior edge of the frame 515 may be outside of the sidewall surface 514 of the glass substrate 510.

As will be appreciated in greater detail below, the structure of the frame 515 in Figures 5A and 5B allows for simple singulation of the package substrate 550 from the reconstituted panel. This is because the singulation process does not need to pass through glass. This is a significant advantage over existing solutions since cutting through the glass substrate 510 can result in significant damage (e.g., cracking, seware failure, etc.). Further, the singulation process may only pass through the dielectric layer 525 in some embodiments. Additionally, since the cutting is through the dielectric layer 525, the sidewall portion 527 of the dielectric layer 525 remains along the sidewall surface 514 after singulation. This provides additional protection to the glass substrate 510 during subsequent processing.

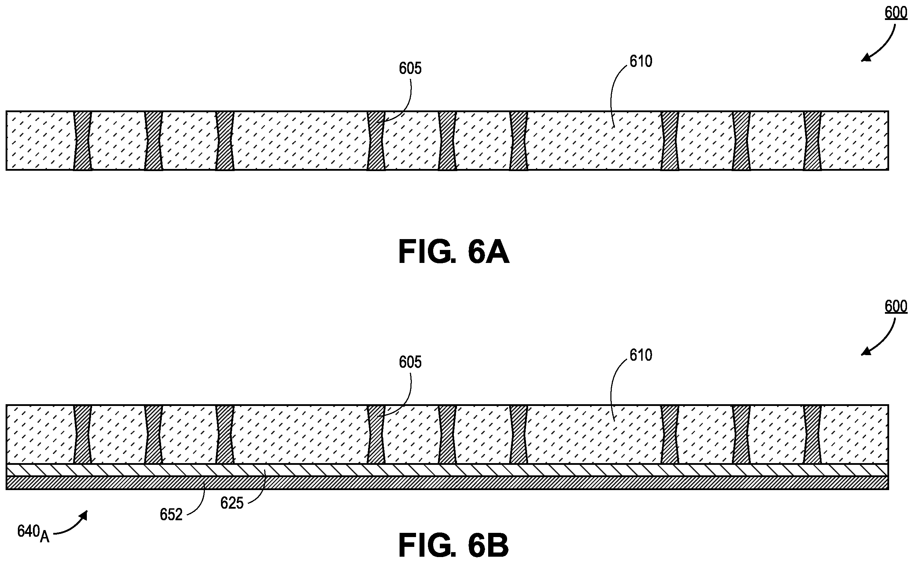

Referring now to Figures 6A - 6J, a series of cross-sectional illustrations depicting a process for forming a package substrate 650 with a glass substrate 610 using a reconstituted panel process is shown, in accordance with an embodiment.

Referring now to Figure 6A, a cross-sectional illustration of the reconstituted panel 600 at a stage of manufacture is shown, in accordance with an embodiment. In an embodiment, the reconstituted panel 600 may comprise a glass substrate 610. The glass substrate 610 may be similar to any of the glass substrates described in greater detail herein. In an embodiment, the glass substrate 610 may comprise vias 605 that pass through a thickness of the glass substrate 610. The vias 605 are shown with hourglass shaped cross-sections. However, the vias 605 may have any shaped cross-section, such as any of those described in greater detail herein.

Referring now to Figure 6B, a cross-sectional illustration of the reconstituted panel 600 after a first RCC layer 640_{A} is applied over a surface of the glass substrate 610 is shown, in accordance with an embodiment. While referred to as an RCC layer, it is to be appreciated that any resin coated metal layer may be used in the reconstituted panel 600. In an embodiment, the first RCC layer 640_{A} may comprise a metal layer 652 and a dielectric layer 625 between the metal layer 652 and the glass substrate 610. The first RCC layer 640_{A} may be applied with a lamination process or the like.

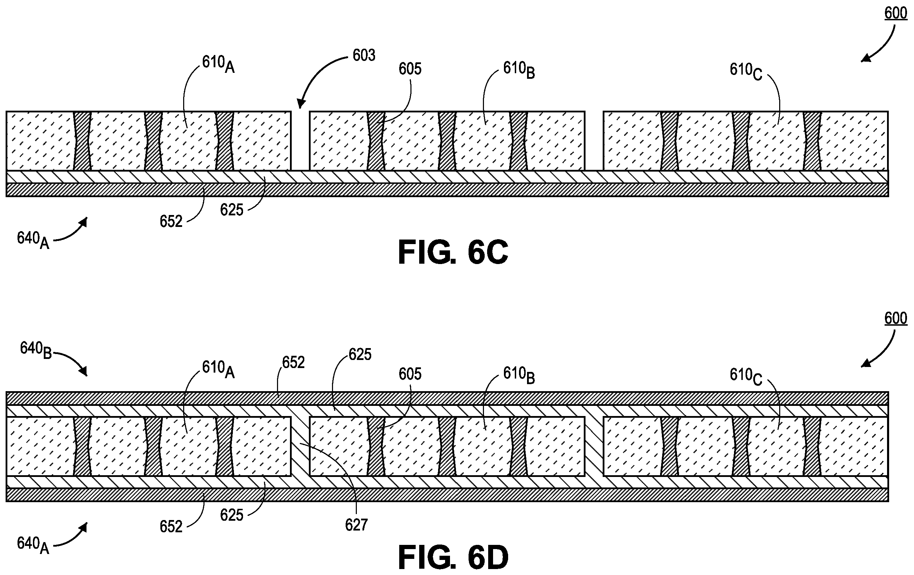

Referring now to Figure 6C, a cross-sectional illustration of the reconstituted panel 600 after the glass substrate 610 is segmented into a plurality of units 610_{A} - 610c is shown, in accordance with an embodiment. The openings 603 used to separate the units 610_{A} - 610_{C} may be formed with an etching process or the like.

Referring now to Figure 6D, a cross-sectional illustration of the reconstituted panel 600 after a second RCC layer 640_{B} is applied over the units 610_{A} - 610c is shown, in accordance with an embodiment. In an embodiment, the second RCC layer 640_{B} may be applied with a lamination process. During the lamination process, the dielectric layer 625 of the second RCC layer 640_{B} may be pressed into the openings 603. Accordingly, units 610_{A} - 610_{C} may be separated by sidewall portions 627 of the dielectric layer 625.

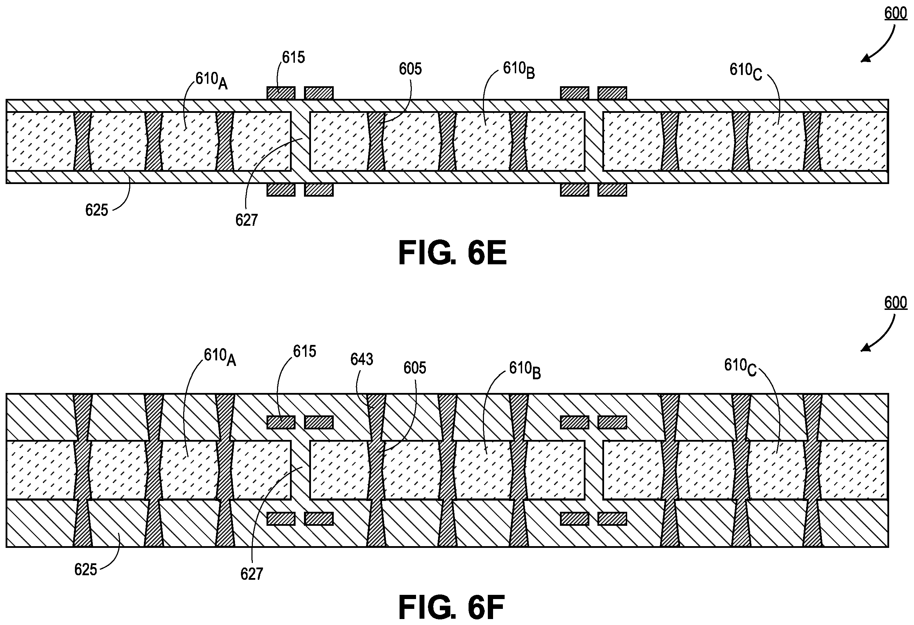

Referring now to Figure 6E, a cross-sectional illustration of the reconstituted panel 600 after the metal layers 652 are patterned to form frames 615 is shown, in accordance with an embodiment. In an embodiment, the metal layers 652 may be patterned with an etching process that uses a patterned resist layer (not shown). A frame 615 may be provided around each of the plurality of units 610_{A} - 610c. The frames 615 may function as a reinforcement layer around the edge of each of the plurality of units 610_{A} - 610c. Additionally, a gap between adjacent frames 615 may be provided over the sidewall portions 627 of the dielectric layer 625.

Referring now to Figure 6F, a cross-sectional illustration of the reconstituted panel 600 after additional buildup layers 625 are provided over the frames 615 is shown, in accordance with an embodiment. In an embodiment, additional buildup layers 625 may be formed with a lamination process or the like. As shown, vias 643 may be provided through the buildup layers 625. The vias 643 may land directly on the vias 605 through the plurality of units 610_{A} - 610_{C}. In the illustrated embodiment, a single monolithic buildup layer 625 is shown. However, it is to be appreciated that multiple discrete layers may be visible in some embodiments. Additionally, the material of the buildup layer 625 between the frames 615 and the plurality of units 610_{A} - 610c may be different than the material of the buildup layer 625 on the opposite side of the frames 615.

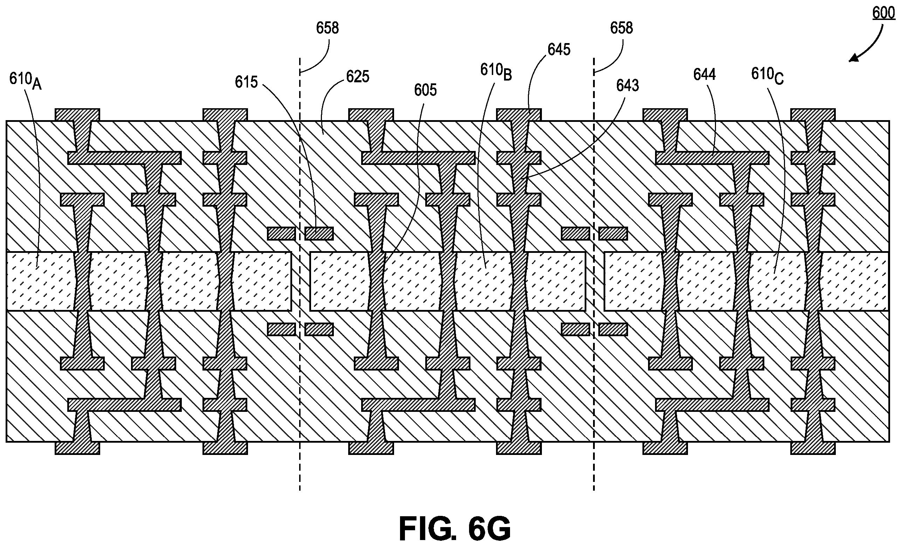

Referring now to Figure 6G, a cross-sectional illustration of the reconstituted panel 600 after completion of the panel assembly is shown, in accordance with an embodiment. As shown, additional buildup layers 625 with electrical routing (e.g., pads 645, traces 644, vias 643, etc.) are provided over the plurality of units 610_{A} - 610c. As shown, cut lines 658 pass through the dielectric layer 625 between the plurality of units 610_{A} - 610_{C}. As can be appreciated, the cut lines 658 where the singulation will occur do not pass through any glass material. As such, the singulation is easier, and the chances of cracking and/or otherwise damaging the plurality of units 610_{A} - 610c is minimized or eliminated.

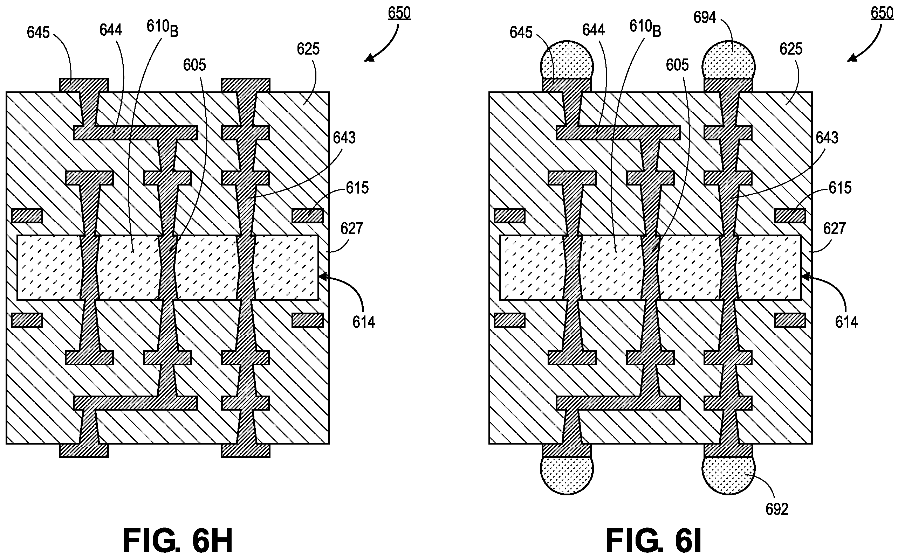

Referring now to Figure 6H, a cross-sectional illustration of a package substrate 650 that has been singulated from the reconstituted panel 600 is shown, in accordance with an embodiment. As shown, a sidewall portion 627 of the dielectric layer 625 is still covering the sidewall surface 614 of the unit 610_{B}. Accordingly, the glass core of the package substrate 650 remains protected throughout subsequent processing operations.

Referring now to Figure 6I, a cross-sectional illustration of the package substrate 650 after interconnects 692 and 694 are added to the package substrate 650 is shown, in accordance with an embodiment. Interconnects 692 and 694 may include solder bumps or the like.

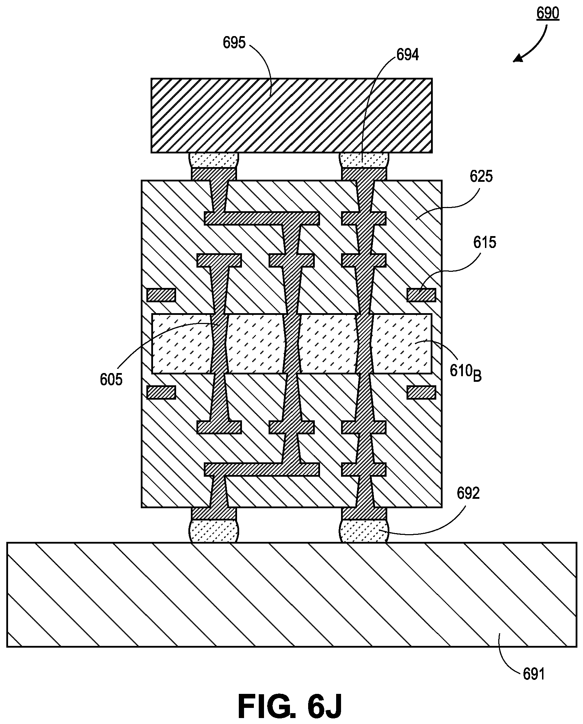

Referring now to Figure 6J, a cross-sectional illustration of an electronic system 690 that includes a package substrate 650 formed from a reconstituted panel 600 is shown, in accordance with an embodiment. The electronic system 690 may comprise a board 691, such as PCB, a motherboard, or the like. In an embodiment, a package substrate 650 may be coupled to the board 691 by interconnects 692. The interconnects 692 may comprise any suitable SLI architecture, such as solder bumps, sockets, pins, or the like.

In an embodiment, the package substrate 650 may be similar to the package substrate 650 formed from a reconstituted panel 600 with a process similar to the one described above with respect to Figures 6A - 6I. For example, a glass unit 610_{B} (i.e., a glass core) may have vias 605. A frame 615 may be provide above and/or below the glass unit 610_{B} to improve mechanical reliability of the package substrate 650. Additionally, the buildup layer 625 may cover all surfaces of the glass unit 610_{B}.

In an embodiment, one or more dies 695 may be coupled to the package substrate 650 by interconnects 694. The interconnects 694 may include any suitable FLI architecture, such as solder, copper bumps, hybrid bonding interfaces, or the like. The dies 695 may comprise one or more types of dies, such as a processor (e.g., a central processing unit (CPU), a graphics processing unit (GPU), etc.), a communications die, a memory die, and/or the like.

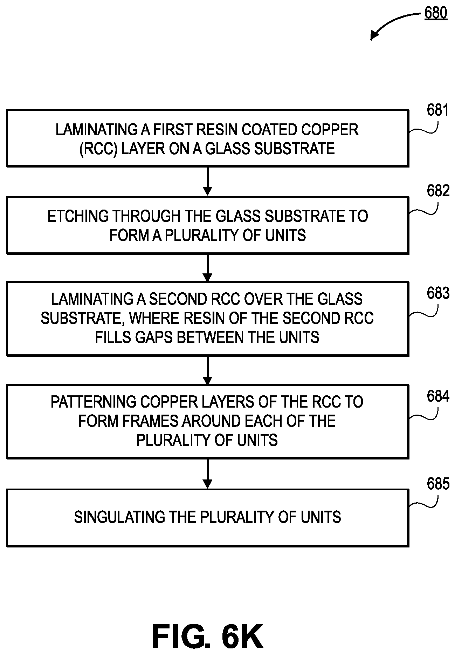

Referring now to Figure 6K, a flow diagram of a process 680 for forming a package substrate from a reconstituted panel is shown, in accordance with an embodiment. In an embodiment, the process 680 may form reconstituted panels and/or package substrates that are similar to the reconstituted panels 600 and package substrates 650 described in greater detail herein. In an embodiment, the process 680 may begin with operation 681, which comprises laminating a first RCC layer on a glass substrate. While referred to as an RCC, it is to be appreciated that any resin coated metal layer may be used in other embodiments.

In an embodiment, the process 680 may continue with operation 682, which comprises etching through the glass substrate to form a plurality of units. In an embodiment, the plurality of units are separated from each other by a gap. In an embodiment, the process 680 may continue with operation 683, which comprises laminating a second RCC over the glass substrate. In an embodiment, resin of the second RCC at least partially fills the gaps between the units.

In an embodiment, the process 680 may continue with operation 684, which comprises patterning metal layers of the first and second RCC to form frames around each of the plurality of units. In an embodiment, the adjacent frames may be spaced apart from each other by a gap as well. After the frames are formed, the reconstituted panel may be completed by forming additional buildup layers over the frame and the units. The additional buildup layers may also comprise electrical routing features, such as pads, vias, traces, and/or the like.

In an embodiment, the process 680 may continue with operation 685, which comprises singulating the plurality of units. In an embodiment, the singulation occurs through the gaps between the plurality of units so that the glass substrate does not need to be cut. As such, possible damage to the glass substrate is reduced or eliminated. In some embodiments, the singulation process may include cutting only through dielectric material.

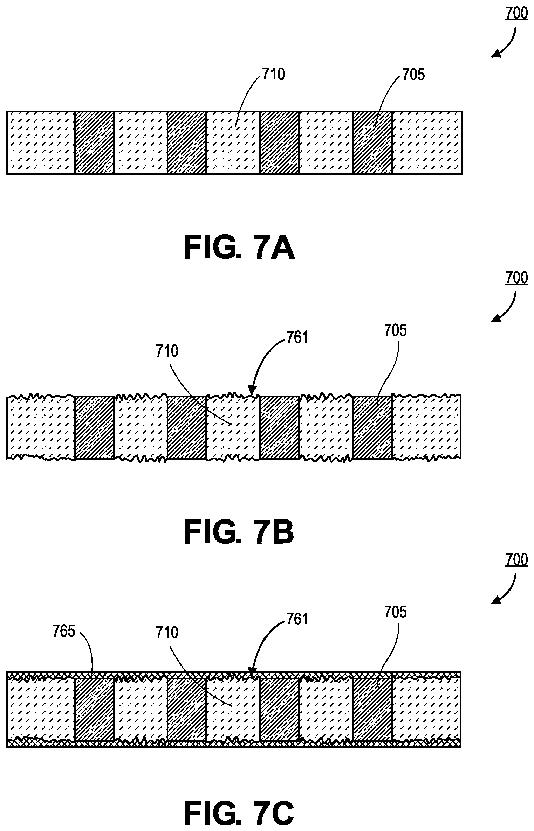

Referring now to Figures 7A - 7F, a series of illustrations depicting a process for forming a hybrid panel 700 with a frame 766 that is formed with an in-situ process is shown, in accordance with an embodiment.

Referring now to Figure 7A, a cross-sectional illustration of the hybrid panel 700 at a stage of manufacture is shown, in accordance with an embodiment. In an embodiment, the hybrid panel 700 comprises a glass substrate 710. The glass substrate 710 may be similar to any of the glass substrates described in greater detail herein. In an embodiment, one or more vias 705 may pass through a thickness of the glass substrate 710. The vias 705 are shown with vertical sidewalls. Though, it is to be appreciated that the vias 705 may have any cross-sectional shape, such as any of the via shapes described in greater detail herein.

Referring now to Figure 7B, a cross-sectional illustration of the hybrid panel 700 after a surface roughening process is implemented is shown, in accordance with an embodiment. As shown, the horizontal surfaces 761 (i.e., the top surface and the bottom surface) of the glass substrate 710 have been roughened in order to increase an average surface roughness (Ra) of the glass substrate 710. In an embodiment, the average surface roughness (Ra) may be approximately 100nm or greater. In an embodiment, the roughening process may include a micro etching process, a plasma treatment, and/or the like. The use of a surface roughening process on the horizontal surfaces 761 can be used to improve the adhesion strength between subsequent layers and the glass substrate 710. This decreases delamination defects in the hybrid panel 700. While a surface roughening process is illustrated, other embodiments may include the deposition of an adhesion promoter (e.g., an organic or inorganic material) that is provided directly on the glass substrate 710.

Referring now to Figure 7C, a cross-sectional illustration of the hybrid panel 700 after metal foil layers 765 are laminated over the glass substrate 710 is shown, in accordance with an embodiment. In an embodiment, the metal foil layers 765 may comprise copper foil or the like. The metal foil layers 765 substantially conform to the roughened horizontal surfaces 761. The increased surface area and the mechanical coupling of the roughened surface improves the adhesion strength between the metal foil layers 765 and the glass substrate 710.

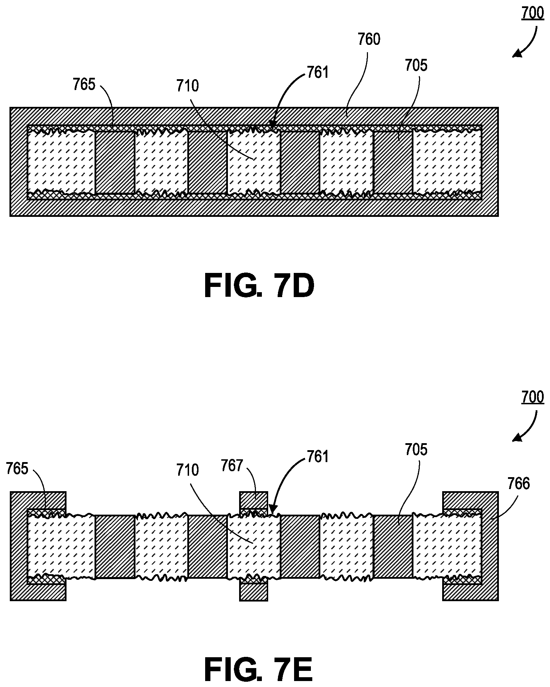

Referring now to Figure 7D, a cross-sectional illustration of the hybrid panel 700 after a metal layer 760 is plated around the glass substrate 710 is shown, in accordance with an embodiment. In an embodiment, the metal layer 760 may be plated with an electroplating process. The metal layer 760 may be provided over the top, bottom, and sidewall surfaces of the glass substrate 710.

Referring now to Figure 7E, a cross-sectional illustration of the hybrid panel 700 after the metal layer 760 and the metal foil layers 765 are patterned is shown, in accordance with an embodiment. The layers may be patterned with the use of a patterned resist (not shown) and etching process. In an embodiment, the remaining portions of the metal layer 760 and the metal foil layers 765 form a frame 766 around a perimeter of the glass substrate 710. The frame 766 may wrap around the edge of the glass substrate 710 so that the frame 766 covers a portion of the top surface, a portion of the bottom surface, and the sidewall surface of the glass substrate 710. In an embodiment, a cross member 767 may also be provided across the glass substrate 710. The cross member 767 may be used to segment the glass substrate 710 into sub-regions, such as quarter panel regions and/or unit regions.

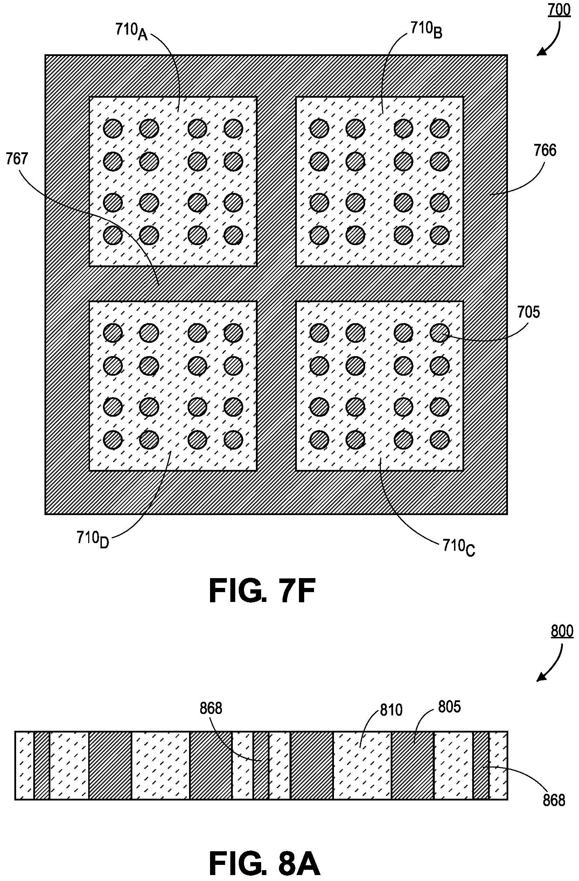

Referring now to Figure 7F, a plan view illustration of the hybrid panel 700 in Figure 7E is shown, in accordance with an embodiment. As shown, the cross member 767 forms a cross that segments the glass substrate 710 in four quarter panel regions 710_{A} - 710_{D}.

Referring now to Figures 8A - 8E, a series of cross-sectional illustrations depicting a process for forming a hybrid panel 800 with a frame 866 with dummy vias 868 that is formed with an in-situ process is shown, in accordance with an embodiment.

Referring now to Figure 8A, a cross-sectional illustration of the hybrid panel 800 at a stage of manufacture is shown, in accordance with an embodiment. In an embodiment, the hybrid panel 800 comprises a glass substrate 810. The glass substrate 810 may be similar to any of the glass substrates described in greater detail herein. In an embodiment, one or more vias 805 may pass through a thickness of the glass substrate 810. The vias 805 are shown with vertical sidewalls. Though, it is to be appreciated that the vias 805 may have any cross-sectional shape, such as any of the via shapes described in greater detail herein.

Figure 8A also illustrates the presence of dummy vias 868. The dummy vias 868 may be provided in a ring pattern proximate to an edge of the glass substrate 810. Dummy vias 868 may also be provided in a cross pattern within the glass substrate 810. The dummy vias 868 are designed to provide additional mechanical anchoring for the frame and the cross member that will be formed in subsequent processing operations. That is, the dummy vias 868 may not be part of the electrical circuitry of the hybrid panel 800.

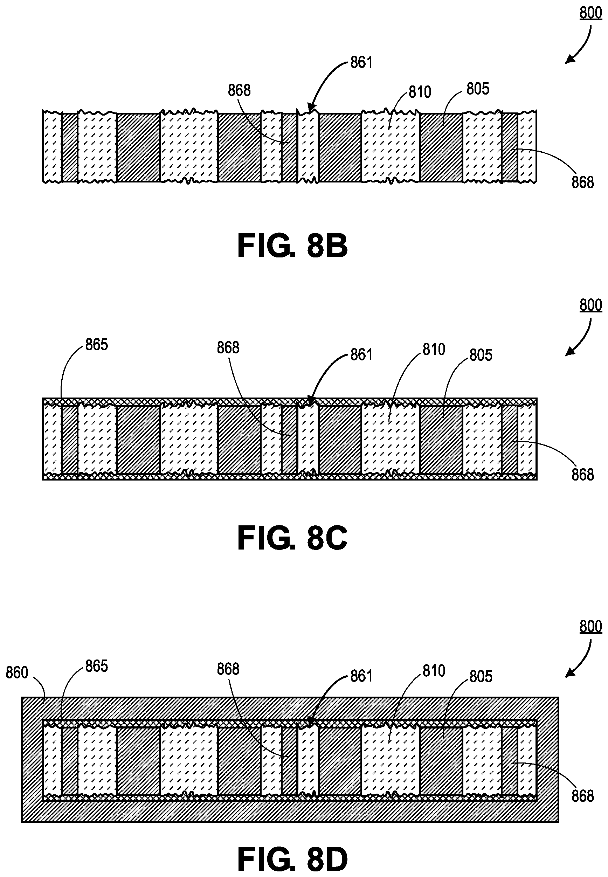

Referring now to Figure 8B, a cross-sectional illustration of the hybrid panel 800 after a surface roughening process is implemented is shown, in accordance with an embodiment. As shown, the horizontal surfaces 861 (i.e., the top surface and the bottom surface) of the glass substrate 810 have been roughened in order to increase an average surface roughness (Ra) of the glass substrate 810. In an embodiment, the average surface roughness (Ra) may be approximately 100nm or greater. In an embodiment, the roughening process may include a micro etching process, a plasma treatment, and/or the like. The use of a surface roughening process on the horizontal surfaces 861 can be used to improve the adhesion strength between subsequent layers and the glass substrate 810. This decreases delamination defects in the hybrid panel 800. While a surface roughening process is illustrated, other embodiments may include the deposition of an adhesion promoter (e.g., an organic or inorganic material) that is provided directly on the glass substrate 810.

Referring now to Figure 8C, a cross-sectional illustration of the hybrid panel 800 after metal foil layers 865 are laminated over the glass substrate 810 is shown, in accordance with an embodiment. In an embodiment, the metal foil layers 865 may comprise copper foil or the like. The metal foil layers 865 substantially conform to the roughened horizontal surfaces 861. The increased surface area and the mechanical coupling of the roughened surface improves the adhesion strength between the metal foil layers 865 and the glass substrate 810.

Referring now to Figure 8D, a cross-sectional illustration of the hybrid panel 800 after a metal layer 860 is plated around the glass substrate 810 is shown, in accordance with an embodiment. In an embodiment, the metal layer 860 may be plated with an electroplating process. The metal layer 860 may be provided over the top, bottom, and sidewall surfaces of the glass substrate 810.

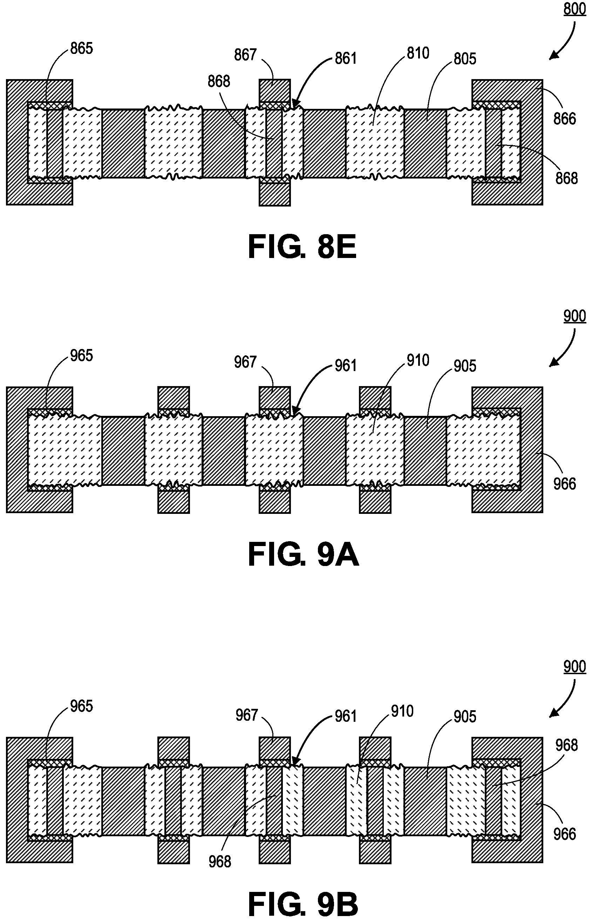

Referring now to Figure 8E, a cross-sectional illustration of the hybrid panel 800 after the metal layer 860 and the metal foil layers 865 are patterned is shown, in accordance with an embodiment. The layers may be patterned with the use of a patterned resist (not shown) and etching process. In an embodiment, the remaining portions of the metal layer 860 and the metal foil layers 865 form a frame 866 around a perimeter of the glass substrate 810. The frame 866 may wrap around the edge of the glass substrate 810 so that the frame 866 covers a portion of the top surface, a portion of the bottom surface, and the sidewall surface of the glass substrate 810. Additionally, dummy vias 868 are provided between the top portion of the frame 866 and the bottom portion of the frame 866 in order to improve the mechanical coupling of the frame 866 to the glass substrate 810.

In an embodiment, a cross member 867 may also be provided across the glass substrate 810. The cross member 867 may be used to segment the glass substrate 810 into sub-regions, such as quarter panel regions and/or unit regions. Additionally, dummy vias 868 are provided between the top cross member 867 and the bottom cross member 867 in order to improve the mechanical coupling of the cross members 867 to the glass substrate 810.

Referring now to Figure 9A - 9C a series of illustrations depicting hybrid panels 900 that include cross members 967 that segregate the glass substrate 910 into individual units is shown, in accordance with various embodiments. The process for forming the hybrid panels 900 in Figures 9A - 9C is similar to the process described with respect to Figures 7A - 7E and/or Figures 8A - 8E, with a modification to the etching process in order to provide additional cross members.

Referring now to Figure 9A, a cross-sectional illustration of a hybrid panel 900 is shown, in accordance with an embodiment. In an embodiment, the hybrid panel 900 comprises a glass substrate 910. The glass substrate 910 may be similar to any of the glass substrates described in greater detail herein. As shown, the horizontal surfaces 961 may be roughened (e.g., with an average roughness (Ra) that is approximately 100nm or greater), similar to the horizontal surfaces 861 described in greater detail above. In an embodiment, vias 905 may pass through a thickness of the glass substrate 910. The vias 905 may be similar to any of the through glass vias described in greater detail herein.

In an embodiment, an in-situ formed frame 966 may be provided around a perimeter of the glass substrate 910. In an embodiment, the frame 966 may be provided over a top surface, a bottom surface, and a sidewall surface of the glass substrate 910. The top portion of the frame 966 and the bottom portion of the frame 966 may be separated from the glass substrate by a metal foil layer 965. In an embodiment, a plurality of cross members 967 may be provided across the surfaces of the glass substrate 910 in order to segregate the glass substrate 910 into a plurality of units. Each unit may ultimately be singulated to form a single package substrate (not shown).

Referring now to Figure 9B, a cross-sectional illustration of a hybrid panel 900 is shown, in accordance with an additional embodiment. The hybrid panel 900 in Figure 9B may be substantially similar to the hybrid panel 900 in Figure 9A, with the addition of dummy vias 968. In an embodiment, dummy vias 968 may be arranged in a ring pattern proximate to a perimeter of the glass substrate 910. The dummy vias 968 may mechanically couple the top portion of the frame 966 to the bottom portion of the frame 966. Similarly, dummy vias 968 may be provided between the cross members 967 above and below the glass substrate 910.

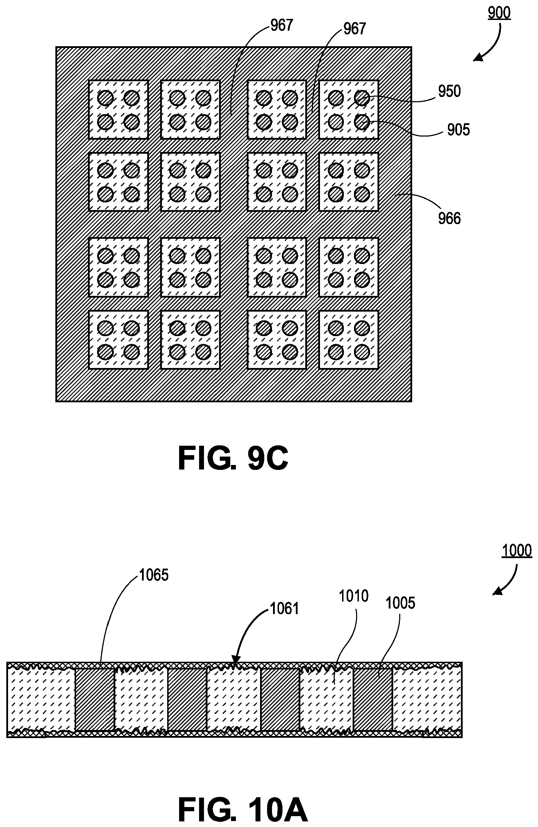

Referring now to Figure 9C, a plan view illustration of the hybrid panel 900 in Figures 9A and 9B is shown, in accordance with an embodiment. As shown, the cross members 967 may segment the glass substrate 910 into a plurality of units 950. For example, each unit 950 in Figure 9C has four vias 905 for illustrative purposes. The cross members 967 may have non-uniform thicknesses, or the cross members 967 may all have substantially uniform thicknesses.

Referring now to Figures 10A - 10G, a series of cross-sectional illustrations depicting a process for forming a hybrid panel 1000 with a frame 1066 that is spaced apart from the glass substrate 1010 by a dielectric layer 1072 is shown, in accordance with an embodiment.

Referring now to Figure 10A, a cross-sectional illustration of the hybrid panel 1000 at a stage of manufacture is shown, in accordance with an embodiment. In an embodiment, the hybrid panel 1000 comprises a glass substrate 1010. The glass substrate 1010 may be similar to any of the glass substrates described in greater detail herein. In an embodiment, one or more vias 1005 may pass through a thickness of the glass substrate 1010. The vias 1005 are shown with vertical sidewalls. Though, it is to be appreciated that the vias 1005 may have any cross-sectional shape, such as any of the via shapes described in greater detail herein.

As shown in Figure 10A, the horizontal surfaces 1061 (i.e., the top surface and the bottom surface) of the glass substrate 1010 have been roughened in order to increase an average surface roughness (Ra) of the glass substrate 1010. In an embodiment, the average surface roughness (Ra) may be approximately 100nm or greater in some embodiments. In an embodiment, the roughening process may include a micro etching process, a plasma treatment, and/or the like.

In an embodiment, metal foil layers 1065 are laminated over the glass substrate 1010 is shown, in accordance with an embodiment. In an embodiment, the metal foil layers 1065 may comprise copper foil or the like. The metal foil layers 1065 substantially conform to the roughened horizontal surfaces 1061. The increased surface area and the mechanical coupling of the roughened surface improves the adhesion strength between the metal foil layers 1065 and the glass substrate 1010.

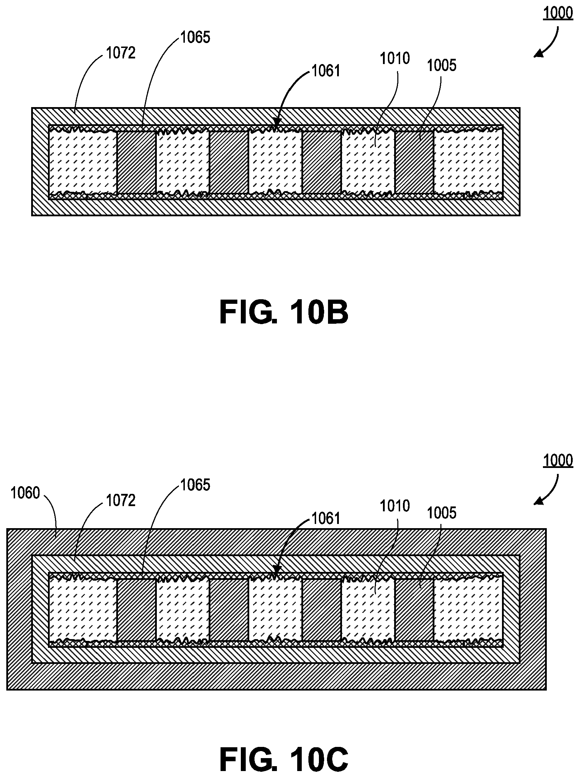

Referring now to Figure 10B, a cross-sectional illustration of the hybrid panel 1000 after a dielectric layer 1072 is applied around the hybrid panel 1000 is shown, in accordance with an embodiment. The dielectric layer 1072 may comprise an organic dielectric layer, such as a buildup film or the like. The dielectric layer 1072 covers the metal foil layers 1065 and the sidewalls of the glass substrate 1010.

Referring now to Figure 10C, a cross-sectional illustration of the hybrid panel 1000 after a metal layer 1060 is plated around the dielectric layer 1072 is shown, in accordance with an embodiment. In an embodiment, the metal layer 1060 may be plated with an electroplating process. For example, a seed layer (not shown) may be provided over the dielectric layer 1072 before the electroplating process. The metal layer 1060 may be provided over the top, bottom, and sidewall surfaces of the dielectric layer 1072.

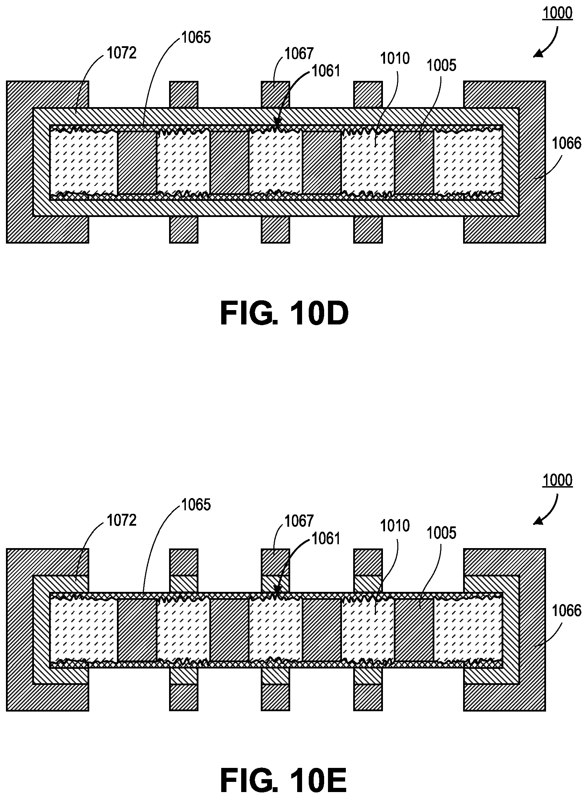

Referring now to Figure 10D, a cross-sectional illustration of the hybrid panel 1000 after the metal layer 1060 is patterned is shown, in accordance with an embodiment. The metal layer 1060 may be patterned with the use of a patterned resist (not shown) and etching process. In an embodiment, the remaining portions of the metal layer 1060 forms a frame 1066 around a perimeter of the glass substrate 1010. The frame 1066 may wrap around the edge of the dielectric layer 1072 so that the frame 1066 covers a portion of the top surface, a portion of the bottom surface, and the sidewall surface of the dielectric layer 1072. In an embodiment, a plurality of cross members 1067 may also be provided across the dielectric layer 1072. The cross members 1067 may be used to segment the glass substrate 1010 into sub-regions, such as unit regions.

Referring now to Figure 10E, a cross-sectional illustration of the hybrid panel 1000 after the dielectric layer 1072 is patterned is shown, in accordance with an embodiment. In an embodiment, an additional etching process may be used in order to transfer the pattern of the frame 1066 and the cross members 1067 into the underlying dielectric layer 1072.

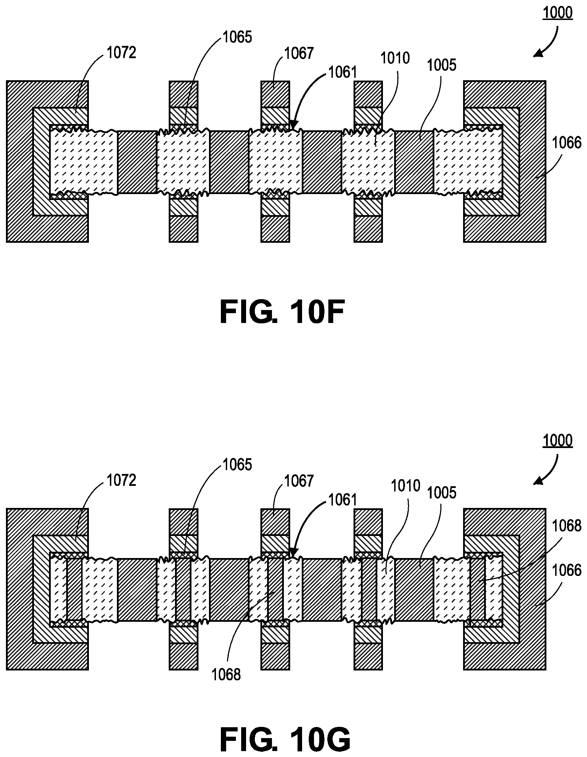

Referring now to Figure 10F, a cross-sectional illustration of the hybrid panel 1000 after the metal foil layer 1065 is patterned is shown, in accordance with an embodiment. In an embodiment, an additional etching process may be used in order to transfer the pattern of the frame 1066 and the cross members 1067 into the underlying metal foil layer 1065 in order to expose portions of the glass substrate 1010 and the vias 1005.

Referring now to Figure 10G, a cross-sectional illustration of a hybrid panel 1000 with an in-situ frame 1066 is shown, in accordance with an alternative embodiment. The hybrid panel 1000 in Figure 10G is similar to the hybrid panel 1000 in Figure 10F, with the exception of the addition of dummy vias 1068. The dummy vias 1068 may be formed into the glass substrate 1010 at the time the vias 1005 are formed. The remainder of the process to form the hybrid panel 1000 in Figure 10G is similar to the process described above with respect to Figures 10A - 10F.

In an embodiment, the dummy vias 1068 may mechanically anchor the frame 1066 to the glass substrate 1010. For example, dummy vias 1068 proximate to an edge of the glass substrate 1010 may mechanically couple an upper portion of the frame 1066 to a lower portion of the frame 1066. Similarly, dummy vias 1068 may mechanically couple the upper cross members 1067 to the lower cross members 1067.

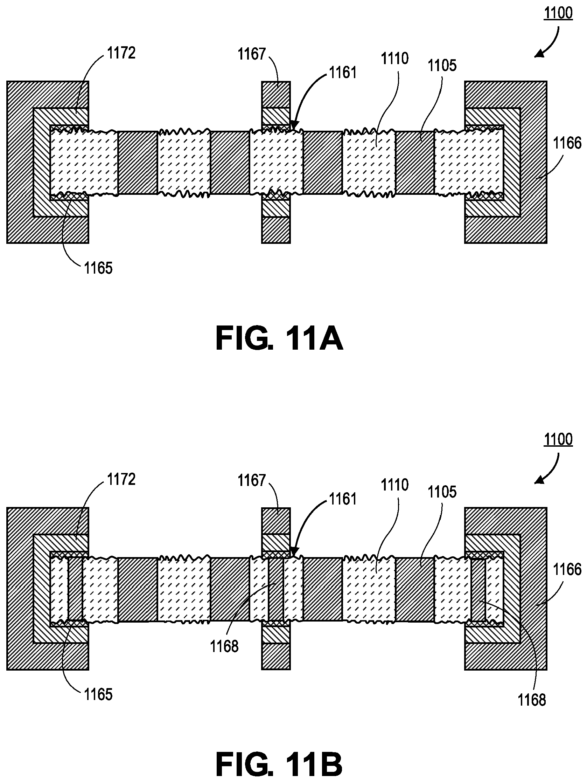

Referring now to Figures 11A and 11B, cross-sectional illustrations of hybrid panels 1100 with in-situ frames 1166 are shown, in accordance with different embodiments. In an embodiment, the hybrid panels 1100 in Figures 11A and 11B may be similar to the hybrid panels 1000 in Figures 10F and 10G, with the exception of the cross members 1167. Instead of segmenting the glass substrate 1110 into unit regions, the cross members 1167 segment the glass substrate 1110 into quarter panel regions.

More generally, the hybrid panels 1100 comprise a glass substrate 1110 with roughened horizontal surfaces 1161. Vias 1105 may be formed through the glass substrate 1110. In an embodiment, the frame 1166 may be spaced away from the glass substrate 1110 by a dielectric layer 1172 and a metal foil layer 1165. The cross members 1167 may also be spaced away from the glass substrate 1110 by the dielectric layer 1172 and the metal foil layer 1165. In Figure 11B, dummy vias 1168 may also provide mechanical coupling of the frame 1166 and the cross members 1167 to the glass substrate 1110.

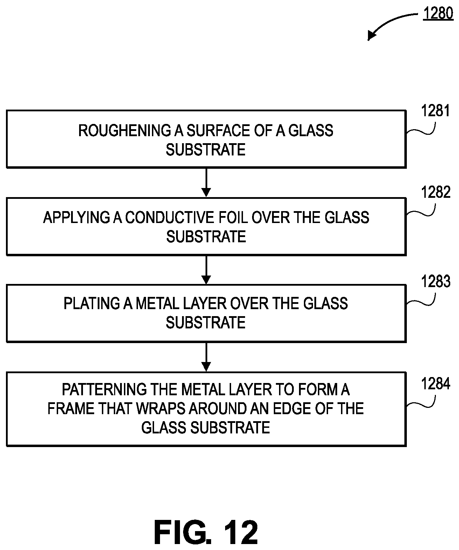

Referring now to Figure 12, a flow diagram of a process 1280 for forming a hybrid panel with a frame formed with an in-situ process is shown, in accordance with an embodiment. In an embodiment, the process 1280 may be used to form any of the hybrid panels 700, 800, 900, 1000, or 1100 described in greater detail herein.

In an embodiment, the process 1280 may begin with operation 1281, which comprises roughening a surface of a glass substrate. In an embodiment, the glass substrate may be roughened with a dry process, a wet process (e.g., etching), or the like. In an embodiment, the process 1280 may continue with operation 1282, which comprises applying a conductive foil over the glass substrate. In an embodiment, the conductive foil is a copper foil that is applied with a lamination process. The conductive foil may conform to the roughened surface in order to improve an adhesion strength between the glass substrate and subsequently formed layers.

In an embodiment, the process 1280 may continue with operation 1283, which comprises plating a metal layer over the glass substrate. In some embodiments, the metal layer may be plated directly over the conductive foil. Other embodiments may include applying a dielectric layer over the conductive foil, and plating the metal layer over the dielectric layer. The metal layer may cover the top surface, the bottom surface, and the sidewall surface of the glass substrate.

In an embodiment, the process 1280 may continue with operation 1284, which comprises patterning the metal layer to form a frame that wraps around an edge of the glass substrate. In an embodiment, the frame may cover a portion of the top surface, a portion of the bottom surface, and the sidewall surface of the glass substrate. The underlying conductive foil may also be patterned to expose the glass substrate again. In an embodiment, the patterning process may also result in the formation of cross members over the top and/or bottom surface of the glass substrate in order to segment the glass substrate into sub-regions (e.g., quarter panel regions or unit regions). In some embodiments, the frame and/or the cross members may be mechanically anchored to the glass substrate with dummy vias, such as those described in greater detail herein.

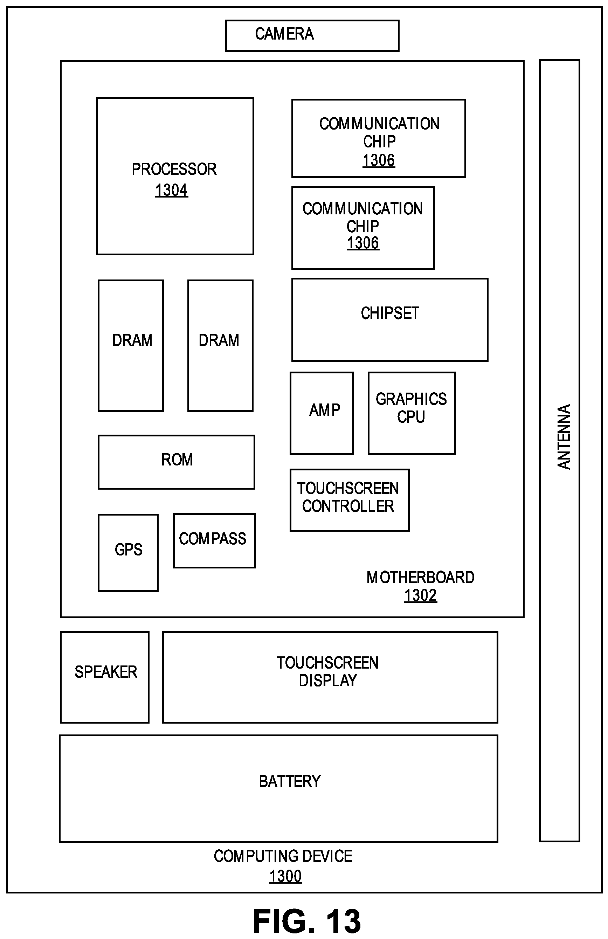

Figure 13 illustrates a computing device 1300 in accordance with one implementation of the disclosure. The computing device 1300 houses a board 1302. The board 1302 may include a number of components, including but not limited to a processor 1304 and at least one communication chip 1306. The processor 1304 is physically and electrically coupled to the board 1302. In some implementations the at least one communication chip 1306 is also physically and electrically coupled to the board 1302. In further implementations, the communication chip 1306 is part of the processor 1304.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1306 enables wireless communications for the transfer of data to and from the computing device 1300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1306 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1300 may include a plurality of communication chips 1306. For instance, a first communication chip 1306 may be dedicated to shorter range wireless communications such as Wi-Fi and Bluetooth and a second communication chip 1306 may be dedicated to longer range wireless communications such as GPS, EDGE, GPRS, CDMA, WiMAX, LTE, Ev-DO, and others.

The processor 1304 of the computing device 1300 includes an integrated circuit die packaged within the processor 1304. In some implementations of the disclosure, the integrated circuit die of the processor may be part of an electronic package that comprises a package substrate with a glass core with a dielectric layer over sidewalls of the glass core and/or an integrated frame over the glass core for reinforcing the glass core, in accordance with embodiments described herein. The term "processor" may refer to any device or portion of a device that processes electronic data from registers and/or memory to transform that electronic data into other electronic data that may be stored in registers and/or memory.

The communication chip 1306 also includes an integrated circuit die packaged within the communication chip 1306. In accordance with another implementation of the disclosure, the integrated circuit die of the communication chip may be part of an electronic package that comprises a package substrate with a glass core with a dielectric layer over sidewalls of the glass core and/or an integrated frame over the glass core for reinforcing the glass core, in accordance with embodiments described herein.

In an embodiment, the computing device 1300 may be part of any apparatus. For example, the computing device may be part of a personal computer, a server, a mobile device, a tablet, an automobile, or the like. That is, the computing device 1300 is not limited to being used for any particular type of system, and the computing device 1300 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a substrate, wherein the substrate comprises a glass layer; a frame around the substrate, wherein a gap is provided between an edge of the substrate and an interior edge of the frame; a fill layer in the gap, wherein the fill layer comprises a dielectric material; and a ring over the fill layer around a perimeter of the substrate, wherein the ring comprises a metallic material.

Example 2: the apparatus of Example 1, wherein the ring is within a footprint of the substrate and within a footprint of the frame.

Example 3: the apparatus of Example 1 or Example 2, wherein the frame comprises an organic dielectric material.

Example 4: the apparatus of Examples 1-3, further comprising: a buildup layer over the substrate and the ring.

Example 5: the apparatus of Example 4, wherein the buildup layer is over the frame.

Example 6: the apparatus of Example 5, wherein an edge of the buildup layer is set back from an outer edge of the frame.

Example 7: the apparatus of Examples 1-6, further comprising: a via through the substrate; and a pad on the via over a surface of the substrate.

Example 8: the apparatus of Example 7, wherein a thickness of the pad is substantially equal to a thickness of the ring.

Example 9: the apparatus of Examples 1-8, wherein the ring is a continuous ring around a perimeter of the substrate, or wherein the ring comprises two or more segments.

Example 10: the apparatus of Examples 1-9, wherein the substrate has a panel level form factor or a quarter panel level form factor.

Example 11: an apparatus, comprising: a substrate, wherein the substrate comprises a glass layer; a via through a thickness of the substrate; a first layer around the substrate, wherein the first layer is a dielectric material that is over the substrate, under the substrate, and over sidewalls of the substrate; a second layer over the first layer, wherein the second layer comprises a first metallic material; and a third layer over the second layer, wherein the second layer comprises a second metallic material.

Example 12: the apparatus of Example 11, further comprising: a via between the third layer and the substrate, wherein the via passes through the second layer, and wherein the via comprises the second metallic material.

Example 13: the apparatus of Example 11 or Example 12, wherein the first metallic material is substantially the same as the second metallic material.

Example 14: the apparatus of Examples 11-13, wherein the first metallic material is different than the second metallic material.

Example 15: the apparatus of Examples 11-14, further comprising a hole through a thickness of the substrate.

Example 16: the apparatus of Example 15, further comprising a component in the hole.

Example 17: the apparatus of Examples 11-16, further comprising: buildup layers over the third layer, wherein the buildup layers comprise electrical routing.

Example 18: the apparatus of Example 17, further comprising: a die coupled to the buildup layers; and a board coupled to the substrate.

Example 19: the apparatus of Examples 11-18, further comprising: a via through the substrate.

Example 20: the apparatus of Examples 11-19, wherein the second layer directly contacts the third layer.

Example 21: an apparatus, comprising: a substrate, wherein the substrate comprises a glass layer; a layer on the substrate, wherein the layer covers a first surface of the substrate, a second surface of the substrate opposite from the first surface, and a sidewall surface of the substrate, and wherein the layer is an organic dielectric material; and a frame over the substrate, wherein the frame is spaced apart from the first surface of the substrate by a portion of the layer.

Example 22: the apparatus of Example 21, wherein the frame has an outer edge that is outside of a footprint of the substrate and an inner edge that is within the footprint of the substrate.

Example 23: the apparatus of Example 21 or Example 22, wherein the frame is entirely outside of a footprint of the substrate.

Example 24: the apparatus of Examples 21-23, wherein the frame comprises a metallic material.

Example 25: the apparatus of Examples 21-24, wherein the frame is a continuous ring, or wherein the frame comprises a plurality of segments.

Example 26: the apparatus of Examples 21-25, wherein the frame has an outer edge that is set back from a sidewall of the layer.

Example 27: the apparatus of Examples 21-26, further comprising a via through at least a portion of the layer, wherein the frame is positioned between a top surface of the via and a bottom surface of the via.

Example 28: the apparatus of Example 27, further comprising: a second via through a thickness of the substrate, wherein the via lands directly onto the second via.

Example 29: the apparatus of Examples 21-28, further comprising: buildup layers over and under the layer, wherein the buildup layers comprise electrical routing.

Example 30: the apparatus of Example 29, further comprising: a die coupled to the buildup layers over the layer; and a board coupled to the buildup layers under the layer.

Example 31: an apparatus, comprising: a substrate with a first surface, a second surface opposite from the first surface, and a sidewall that couples the first surface to the second surface, wherein the substrate comprises a glass layer; a frame on the substrate, wherein the frame wraps around an edge of the substrate and is over the first surface, the second surface, and the sidewall surface of the substrate; and a foil between the frame and the substrate along the first surface and the second surface.

Example 32: the apparatus of Example 31, wherein an average surface roughness (Ra) of the first surface and the second surface is approximately 100nm or greater.

Example 33: the apparatus of Example 32, wherein the foil substantially conforms to the first surface and the second surface.

Example 34: the apparatus of Examples 31-33, further comprising an adhesion promotor layer between the foil and the first surface of the second surface.

Example 35: the apparatus of Examples 31-34, further comprising: a cross member over the first surface of the substrate, wherein the cross member is coupled to the frame.

Example 36: the apparatus of Example 35, wherein the cross member defines quarter panel regions of the substrate, or wherein the cross member defines unit regions of the substrate.

Example 37: the apparatus of Examples 31-36, further comprising: a via through the substrate, wherein the via couples a top portion of the frame to a bottom portion of the frame.

Example 38: the apparatus of Examples 31-37, further comprising: a layer between the foil and the frame, wherein the layer comprises an organic dielectric material.

Example 39: the apparatus of Example 38, wherein the substrate has a panel level form factor or a quarter panel level form factor.

Example 40: the apparatus of Examples 31-39, wherein the frame has a first thickness that is greater than a second thickness of the substrate.

## Claims

1. An apparatus, comprising:
a substrate, wherein the substrate comprises a glass layer;
a frame around the substrate, wherein a gap is provided between an edge of the substrate and an interior edge of the frame;
a fill layer in the gap, wherein the fill layer comprises a dielectric material; and
a ring over the fill layer around a perimeter of the substrate, wherein the ring comprises a metallic material.

2. The apparatus of claim 1, wherein the ring is within a footprint of the substrate and within a footprint of the frame.

3. The apparatus of claim 1 or 2, wherein the frame comprises an organic dielectric material.

4. The apparatus of claim 1, 2 or 3, further comprising:
a buildup layer over the substrate and the ring.

5. The apparatus of claim 4, wherein the buildup layer is over the frame.

6. The apparatus of claim 5, wherein an edge of the buildup layer is set back from an outer edge of the frame.

7. The apparatus of claim 1, 2, 3, 4, 5 or 6, further comprising:
a via through the substrate; and
a pad on the via over a surface of the substrate.

8. The apparatus of claim 7, wherein a thickness of the pad is substantially equal to a thickness of the ring.

9. The apparatus of claim 1, 2, 3, 4, 5, 6, 7 or 8, wherein the ring is a continuous ring around a perimeter of the substrate, or wherein the ring comprises two or more segments.

10. The apparatus of claim 1, 2, 3, 4, 5, 6, 7, 8 or 9, wherein the substrate has a panel level form factor or a quarter panel level form factor.

11. A method of fabricating an apparatus, the method comprising:
providing a substrate, wherein the substrate comprises a glass layer;
forming a frame around the substrate, wherein a gap is provided between an edge of the substrate and an interior edge of the frame;
forming a fill layer in the gap, wherein the fill layer comprises a dielectric material; and
forming a ring over the fill layer around a perimeter of the substrate, wherein the ring comprises a metallic material.

12. The method of claim 11, wherein the ring is within a footprint of the substrate and within a footprint of the frame.

13. The method of claim 11 or 12, wherein the frame comprises an organic dielectric material.

14. The method of claim 11, 12 or 13, further comprising:
forming a buildup layer over the substrate and the ring.

15. The method of claim 14, wherein the buildup layer is over the frame.
